# EUROPÄISCHE PATENTSCHRIFT

(11) **EP 2 311 048 B1**
(45) Veröffentlichungstag und Bekanntmachung des Hinweises auf die Patenterteilung: **29.04.2015**
(21) Anmeldenummer: 09804527.1
(22) Anmeldetag: 07.08.2009
(51) Int. Cl.: H01B 1/24, C08J 7/18, H05K 1/00, C08J 5/00

(54) **POLYMERFORMKÖRPER UND LEITERPLATTEN-ANORDNUNG, SOWIE VERFAHREN ZU DEREN HERSTELLUNG**
POLYMER FORM BODY WITH CONDUCTIVE STRUCTURES ON THE SURFACE AND METHOD FOR ITS PRODUCTION
CORPS DE FORMAGE POLYMÈRE DOTÉ DE STRUCTURES CONDUCTRICES SUR LA SURFACE ET SON PROCÉDÉ DE FABRICATION

(30) Priorität: 08.08.2008 EP 08162124; 23.09.2008 DE 102008048459; 08.12.2008 DE 102008061051; 03.03.2009 DE 102009011538
(43) Veröffentlichungstag der Anmeldung: 20.04.2011
(73) Patentinhaber: pp-mid GmbH, 07745 Jena (DE)
(72) Erfinder: PUTSCH, Peter, 91080 Rathsberg (DE)
(74) Vertreter: Andrae | Westendorp Patentanwälte Partnerschaft
(86) Internationale Anmeldenummer: PCT/EP2009/005757
(87) Internationale Veröffentlichungsnummer: WO 2010/015420

(56) Entgegenhaltungen:
- EP-A- 1 719 804
- WO-A-2004/069736
- US-A1- 2006 062 983
- DATABASE CA [Online] CHEMICAL ABSTRACTS SERVICE, COLUMBUS, OHIO, US; SAKAI, TAKAMITSU: "Electronic device" XP002552598 gefunden im STN Database accession no. 2009:426686 & JP 2009 076568 A (DENSO CO., LTD., JAPAN) 9. April 2009 (2009-04-09)
- DATABASE CA [Online] CHEMICAL ABSTRACTS SERVICE, COLUMBUS, OHIO, US; YAMAGUCHI, KOICHI ET AL: "Nanotube or nanowire compositions, moldings and dielectric films from them, their manufacture, and metal foils, printed circuit boards, and high-frequency electronic parts using them" XP002552653 gefunden im STN Database accession no. 2007:167607 & JP 2007 039567 A (KANSAI RESEARCH INSTITUTE INC., JAPAN; FUJIFILM HOLDINGS CORP.; NIPPON) 15. Februar 2007 (2007-02-15)
- DATABASE CA [Online] CHEMICAL ABSTRACTS SERVICE, COLUMBUS, OHIO, US; LEE, JAE HONG ET AL: "Light-emitting diode package using binder containing carbon nanomaterials" XP002552600 gefunden im STN Database accession no. 2009:57917 & KR 2009 003 432 A (SEOUL SEMICONDUCTOR CO., LTD., S. KOREA) 12. Januar 2009 (2009-01-12)

## Beschreibung

Die vorliegende Erfindung betrifft Polymerformkörper mit leitfähigen, insbesondere elektrisch leitfähigen, Strukturen auf der Oberfläche, sowie ein Verfahren zur Erhöhung der elektrischen Leitfähigkeit eines Polymerformkörpers. Ein weiterer Aspekt der Erfindung betrifft die Verwendung eines Geräts zur Erzeugung der leitfähigen, insbesondere der elektrisch leitfähigen, Strukturen auf der Oberfläche des Polymerformkörpers. Zudem betrifft die Erfindung die Verwendung eines Klebstoffes, enthaltend Carbon Nanotubes (CNT), zum Anbringen von elektronischen Bauelementen auf dem erfindungsgemäßen Polymerkörper.

Die Erfindung betrifft zudem eine Leiterplatten-Anordnung, umfassend mindestens eine Leiterplatte mit mindestens einer elektrisch leitfähigen Leiterbahn. Bevorzugterweise umfasst die mindestens eine elektrisch leitfähige Leiterbahn eine Metallschicht, und/oder mindestens ein elektronisches Bauelement.

Die Erfindung betrifft auch Verfahren zur Herstellung der erfindungsgemäßen Leiterplatten-Anordnungen.

Elektrisch leitfähige Kunststoffe sind seit langem bekannt. US 4,404,125 beschreibt die Herstellung derartiger Kunststoffe durch Beimengung von Kohlenstofffasern, gegebenenfalls zusammen mit leitfähigen Rußen, in einen thermoplastischen Kunststoff. In US 4,664,971 werden an Stelle der Kohlenstofffasern elektrisch leitfähige Metallfasern eingesetzt. In all diesen Kunststoffmischungen sind große Mengen an elektrisch leitfähigen Zusatzstoffen erforderlich, die im Regelfall in einem Bereich von 10 - 30 Gew.-% liegen. Dennoch ist die elektrische Leitfähigkeit dieser Kunststoffe, insbesondere an der Oberfläche, noch nicht ausreichend für viele technische Anwendungen.

WO 02/19346 beschreibt den Einsatz metallbeschichteter Carbonfasern zur Herstellung elektrisch leitfähiger Kunststoffe. Hierbei wird z.B. ein energiereicher Laser eingesetzt, um den an der Oberfläche befindlichen Kunststoff zu verdampfen und die darunterliegenden Schichten der elektrisch leitfähigen Zusatzstoffe freizulegen. Ein Nachteil ist die dabei häufig auftretende Leitfähigkeit über das ganze Volumen des Kunststoffes, auch quer zur und über die laserbehandelte Bahn hinaus, und die resultierenden Probleme bei der Anordnung von nebeneinander liegenden Leiterbahnen.

Um eine gute elektrische Leitfähigkeit zu erzielen, sind bei all diesen Verfahren ausreichende Mengen an Zusatzstoffen erforderlich und die Leitfähigkeit ist weitgehend gleichmäßig über das Volumen der Kunststoffformteils verteilt. Mit dem steigenden Füllgrad ist aber im Regelfall eine Verschlechterung der mechanischen Eigenschaften verbunden, so dass bei hohen Füllgraden beispielsweise die Zähigkeit sowie Zug- und Reißfestigkeit deutlich reduziert sind.

Eine weitere Möglichkeit zur Erzeugung elektrisch leitfähiger Strukturen auf Oberflächen wurde von T. Dekker (Carbon-Nanotubes as Molecular Quantum Wires, Physics Today, S. 22-28, 1999) beschrieben. Hierbei werden Carbon Nanotubes aus der Gasphase auf einem Substrat abgeschieden. Dieses Verfahren ist ebenfalls mit einem hohen technischen Aufwand verbunden.

US 2006/0062983 A1 offenbart ein Verfahren, worin ein CNTenthaltender Polymerfilm auf ein Substrat aufgebracht wird. Der CNT-enthaltende Polymerfilm ist leitfähig.

WO 2007/114645 offenbart ein Verfahren zum Aufbringen einer CNT-enthaltenden Polymerschicht auf ein Substrat, unter Verwendung einer wässrigen Dispersion die CNTs enthält.

Elektronische Schaltkreise werden in der Regel durch Aufbringen einer Kupferschicht auf ein Substrat hergestellt, wobei die für den Schaltkreis nicht benötigten Teile der Kupferschicht durch chemische Prozesse weggeätzt werden. Die Herstellung solcher Schaltkreise ist in der Regel sehr aufwändig und umfasst viele Verfahrensschritte.

Bei der Erzeugung von leitfähigen Strukturen kann insbesondere das Galvanisierverfahren eingesetzt werden. Um dieses Verfahren auch für Kunststoffoberflächen verwenden zu können, muss auf der Kunststoffoberfläche zuerst eine leitende Schicht aufgebracht werden, bevor auf galvanischem Wege eine metallische Schicht abgeschieden werden kann. Hierzu geeignete Verfahren sind bekannt und umfassen mehrere einzelne Behandlungsschritte, die aufwändig und umständlich sind. Es wäre daher vorteilhaft, wenn die Kunststoffoberflächen direkt galvanisiert werden könnten.

Eine Variante von Kunststoffbauteilen, die unter Verwendung des Galvanisierverfahrens erzeugt werden können sind Molded Interconnect Devices (MIDs). Bei diesen spritzgegossenen Bauteilen werden metallische Leiterbahnen auf Kunststoffträger aufgebracht. Diese MIDs können auf unterschiedliche Arten hergestellt werden. Eine Möglichkeit besteht darin, den Schaltungsträger im Zweikomponentenspritzguss herzustellen. Ein Kunststoff bildet hierbei den Grundkörper, ein weiterer ist metallisierbar und bildet das Leiterbahnlayout ab. In dem SKW-Verfahren wird zunächst die Leiterbahnstruktur als Vertiefung aus der nichtmetallisierbaren Komponente gespritzt. Anschließend werden diese Bereiche mit der metallisierbaren Komponente aufgefüllt. In den nachfolgenden Schritten werden die entsprechenden Metalle auf den metallisierbaren Kunststoff aufgebracht. Hierbei wird zunächst die Oberfläche des metallisierbaren Kunststoffs aktiviert. Auf diese Oberfläche wird galvanisch Kupfer bis zur gewünschten Stärke aufgebracht.

Ein weiteres Problem in der Technik stellt das Befestigen der elektronischen Bauteile oder elektronischen Bauelemente auf den Leiterplatten dar. Die Bauteile oder Bauelemente müssen hierbei auf einfache Weise so befestigt werden, dass hervorragende oder optimale elektrische Eigenschaften erzielt werden können. Hierzu geeignete Klebstoffe sind beispielsweise aus der EP 0 914 027 oder EP 0 870 418 bekannt. Um eine elektrisch leitfähige Verbindung zwischen den Leiterbahnen und den elektronischen Bauelementen zu erzeugen werden den Kunststoffen hierbei elektrisch leitfähige Stoffe zugesetzt. Allerdings erreichen diese Klebeverbindungen oftmals nicht die gewünschte Leitfähigkeit und Festigkeit und es besteht insbesondere ein Bedarf an neuen Klebstoff-Zusammensetzungen und/oder Bindungen, die hervorragend oder optimal mit den Eigenschaften der Leiterplatten zusammenwirken.

Eine Aufgabe der vorliegenden Erfindung ist es daher, Leiterplatten-Anordnungen bereitzustellen, wobei die Leiterplatten erfindungsgemäße Polymerformkörper mit leitfähigen, insbesondere elektrisch leitfähigen, Strukturen auf der Oberfläche umfassen bzw. darstellen, , wobei die leitfähigen Strukturen gegebenenfalls Metalle, bevorzugterweise Kupfer, enthalten. Zudem soll ein einfaches Verfahren zum Verbinden von elektronischen (oder anderen) Bauteilen bzw. elektronischen (oder anderen) Bauelementen mit den Leiterplatten zur Verfügung gestellt werden.

In einem ersten Aspekt betrifft die Erfindung daher einen Polymerformkörper mit leitfähigen, insbesondere elektrisch leitfähigen, Strukturen auf der Oberfläche gemäß Anspruch 6, sowie ein Verfahren zur Herstellung dieser Polymerformkörper gemäß Anspruch 1.

Eine weitere Aufgabe der vorliegenden Erfindung war es, die bekannten Verfahren zur Erzeugung von leitfähigen Strukturen auf Polymerformkörpern zu vereinfachen und zu verbessern und insbesondere Polymerformkörper mit besonders guten Eigenschaften zur Verfügung zu stellen.

Diese Aufgabe wird durch die hierin definierten Polymerformkörper und das Verfahren zu deren Herstellung gelöst.

Im Rahmen der vorliegenden Erfindung wurde überraschenderweise festgestellt, dass das partielle Anschmelzen der Oberfläche eines Polymerformkörpers, der Carbon Nanotubes enthält, zu einer Migration der CNT an die Oberfläche des Polymerformkörpers führt. Durch gezieltes Anschmelzen der Oberfläche in definierten Bereichen ist es somit auf vorteilhafte Weise möglich, die Konzentration der CNT in diesen Bereichen zu erhöhen und die elektrische und thermische Leitfähigkeit dieser Bereiche zu erhöhen. Folglich bleibt die Konzentration der CNTs in den unbehandelten, d.h. nicht aufgeschmolzenen Bereichen der Oberfläche (die ebenfalls CNTs enthalten), unverändert bzw. nahezu unverändert. Somit weisen die unbehandelten, nicht leitfähigen Oberflächenbereiche die ursprüngliche Konzentration an CNTs auf. Diese ist daher von null verschieden. Im Gegensatz dazu führt das Aufbringen (z.B. durch Aufdrucken) von leitfähigen Strukturen aus CNT-enthaltendem Polymermaterial, auf eine nicht leitfähige Oberfläche (aus einem Material das keine CNTs enthält) zu anderen (nicht erfindungsgemäßen) Polymerformkörpern. Diese weisen zwar eine hohe CNT Konzentration in den leitfähigen Bereichen, jedoch keine CNTs in den nicht leitfähigen Bereichen auf. Das erfindungsgemäße Verfahren unterscheidet sich daher grundsätzlich von einem Verfahren, bei dem leitfähige Strukturen durch Aufbringen von Material auf Oberflächen erzeugt werden. Das erfindungsgemäße Verfahren führt vielmehr dazu, dass eine nicht leitfähige Oberfläche so behandelt wird, dass definierte Bereiche leitfähig werden und die verbleibenden, unbehandelten Bereiche unverändert bzw. nahezu unverändert (nicht leitfähig) bleiben.

Ein Nachweis für die höhere Konzentration der CNT in den elektrisch leitfähigen (thermisch behandelten) Bereichen kann z. B. über lichtmikroskopische oder elektronenmikroskopische Aufnahmen geliefert werden. Hierbei erscheinen beispielsweise bei einem Polymerformkörper aus Polycarbonat und CNT im Lichtmikroskop die Stellen mit hoher CNT-Dichte in schwarzer Farbe, wohingegen die Stellen mit geringer CNT-Dichte, die jedoch (vorzugsweise) nicht null ist, weiß sind.

Im Gegensatz dazu wurde im Rahmen der vorliegenden Erfindung überraschenderweise festgestellt, dass die Verwendung von Polymerformkörpern mit anderen elektrisch leitenden Zusatzstoffen nicht zu einer Migration der leitfähigen Stoffe an die Oberfläche führt. Beispielsweise führte das Anschmelzen von Polymerformkörpern mit leitfähigen Fasersystemen, wie z. B. Aluflakes (Hersteller Alufllakes der Fa. Silverline, GB; verwendete Polymermischung Polycarbonat/Polypropylen, siehe Beispiel) oder Stahlfasern nicht zu einer Migration der leitfähigen Fasern an die Oberfläche. Bei diesen Polymerformkörpern ist daher nur das oben beschriebene Verfahren aus WO 02/19346 anwendbar. Im erfindungsgemäßen Verfahren ist jedoch vorteilhafterweise kein Verdampfen des Polymers auf der Oberfläche des Polymerformkörpers notwendig.

Bei dem erfindungsgemäßen Verfahren ist die Geschwindigkeit der Migration sowohl von der Viskosität der Polymerphasen, durch die sich die CNT bewegen müssen, als auch von der jeweilige Kompatibilität der Oberflächen der CNT und der Polymerphasen, und von der Behandlungsdauer, d.h. der Zeit, die den CNT zur Verfügung steht, um durch das aufgeschmolzene Polymer an die Oberfläche vorzudringen, abhängig. Je länger die Anschmelzung erfolgt, desto besser können die CNT an die Oberfläche wandern, und desto besser ist auch die Erhöhung der elektrischen Leitfähigkeit in den thermisch behandelten Bereichen.

Des Weiteren wurde überraschenderweise festgestellt, dass sich durch Dehnen oder Verbiegen des Polymerformkörpers der Oberflächenwiderstand desselben ändert. Insbesondere wird der Oberflächenwiderstand größer je mehr der Polymerformkörper gedehnt wird. Dies ermöglicht die Anwendung der erfindungsgemäßen Polymerformkörper in Dehnungsmessstreifen.

Die vorliegende Erfindung betrifft daher nach einem Aspekt Polymerformkörper mit leitfähigen, insbesondere elektrisch leitfähigen, Strukturen auf der Oberfläche gemäß Anspruch 6, sowie ein Verfahren zur Herstellung dieser Polymerformkörper gemäß Anspruch 1.

Ein Polymerformkörper im Sinne der vorliegenden Erfindung ist ein beliebig geformter dreidimensionaler Körper oder eine Polymerschicht aus einem oder mehreren verschiedenen Polymeren, die nachfolgend sowohl für das erfindungsgemäße Verfahren als auch für die erfindungsgemäßen Polymerformkörper beschrieben werden, wobei der Polymerformkörper eine Polyolefin-Beimischung von mindestens 10 Gew.-% bezogen auf das Gewicht des Polymerformkörpers umfasst.

Erfindungsgemäß geeignete Polymere sind Thermoplaste, Duroplaste, Elastomere sowie anorganische Polymere und Mischungen daraus, bevorzugt werden Thermoplaste und Duroplaste verwendet.

Erfindungsgemäß bevorzugt umfasst der Polymerformkörper Polyolefine, in einer Beimischung von mindestens 10 Gew.-%, beispielsweise zwischen 10 und 100 Gew.-%, weiter beispielsweise zwischen 10 und 50 Gew.-%, bezogen auf das Gewicht des Polymerformkörpers bzw. der Polymerphase. Besonders bevorzugt besteht der Polymerformkörper aus Polyolefinen, nach einer Ausführungsform aus cyclischen Polyolefinen. Bevorzugte Polyolefine die erfindungsgemäß verwendet werden können sind u.a. cyclische Polyolefine und deren Copolymere. Bevorzugt werden cyclische Polyolefine oder deren Copolymere in Kombination mit Polypropylen, bevorzugterweise linearem Polypropylen, verwendet. Nach einer vorteilhaften Ausführungsform werden etwa 10 bis 50 Gew.-% cyclische Polyolefine als Beimischung, bezogen auf die gesamte Polymerphase verwendet. Cyclische Polyolefine basieren auf cyclischen Olefinmonomeren oder Mischungen aus cyclischen und linearen Olefinmonomeren. Beispielsweise sind cyclische Polyofefine mit dem Handelsnamen Topas^{®}, wie z.B. Topas^{®} (COC) 6015 (kommerziell erhältlich von Topas Advanced Polymers GmbH, Deutschland), besonders gut geeignet. Besonders bevorzugt sind cyclische Polyolefine auf der Basis von Ethylen und Norbornen bzw. Norbornen-Derivaten.

Es hat sich gezeigt, dass die Verwendung von cyclischen Polyolefinen und deren Copolymere zusammen mit oder anstelle von linearem Polypropylen zu einer Erhöhung der Wärmestandfestigkeit der Polymerformkörper führt, was insbesondere bei der Verwendung der Materialien in der Nähe der Wärmequelle (z.B. im Motorraum) vorteilhaft ist.

Zusätzlich bevorzugt beträgt die Vicat-Erweichungstemperatur der erfindungsgemäß verwendeten Polymere zwischen 80°C und 250°C, bevorzugterweise zwischen 100°C und 250°C, weiter bevorzugt zwischen 110°C und 250°C, noch weiter bevorzugt zwischen 130°C und 230°C (gemessen nach DIN EN ISO 306, 5kg). Im Rahmen der Erfindung wurde bei der Verwendung von Topas^{®} (COC) 6015 ein Wert von 150°C erhalten, wohingegen die Verwendung von Polypropylen zu einem Wert von 110°C führte. Die erfindungsgemäß bevorzugte hohe Vicat-Erweichungstemperatur ist insbesondere für Anwendungen mit erhöhtem Wärmestandfestigkeitsbedarf (z.B. Motorraum etc.) sehr vorteilhaft.

Bevorzugte Polymere, die in Mischung mit Polyolefinen verwendet werden können sind Polycarbonat, Acrylnitril-Butadien-Styrol (ABS), Polyamide wie Polyamid 6 (PA 6), Polyamid 6.6 (PA 6.6), Polyamid 6.4 (PA6.4)), Polyamid 12 (PA 12), aromatisches Polyamid, Polyvinylchlorid, Nylon 6,6, Polyvinylfluorid, Polyvinylidenfluorid, Polyphenylenether, Polystyrol, Polyolefine wie Polypropylen oder Polyethylen, Polysulfon, thermoplastisches Polyurethan, Polyethylenterephthalat, Polybutylenterephthalat, thermoplastische Elastomerlegierungen, Acetal, Styrol-Maleinsäureanhydrid, Butadien-Styrol, Polyetheretherketon, Polyethersulfon, Polytetrafluorethen, Polyalkylacrylate, Polymethylmethacrylat, ungesättigte Polyester, Polylactone, Polyepoxide, Polyimine, Polybutadiene, Polyphosphazene, Styrolmaleinsäureanhydrid (SMA), Styrolmethylmethacrylat (SMMA), Polysulfon, Polyvinylacetat und Polyacrylamid. Des Weiteren kann Phenolharz, Polyesterharz, natürlicher oder synthetischer Kautschuk oder Silikonkautschuk verwendet werden. Spezielle Beispiele anorganischer Polymere umfassen Phosphor basierte Verbindungen und Silikone. Die vorstehend aufgezählten Polymere können auf dem Fachmann bekannte Weise hergestellt und verarbeitet werden. Bevorzugterweise werden mindestens zwei, weiter bevorzugt mindestens drei, verschiedene Polymere zur Herstellung des Polymerformkörpers verwendet.

Bevorzugte Polymerblends sind: Polycarbonat/ Polyolefin (insbesondere Polypropylen oder Polyethylen), Polyethylenterephthalate (PET)/ Polyvinylidenfluorid, PET/Nylon 6,6, PET/Polypropylen, PET/Polyethylenmischungen mit hoher Dichte, Polyamid 6 (PA6)/ Acrylonitril-Butadiene-Styrol und Polycarbonat/ Polyolefine (bevorzugt Polypropylen), Polyamid 6 (PA6)/ Polyamid 12 (PA12), Polyamid 6.6 (PA 6.6)/ Polyamid 12 (PA 12), aromatisches Polyamid/ Polyamid 12 (PA 12), Polybutylenterephthalat/thermoplastisches Polyester, und Polyethylenterephthalat/ thermoplastisches Polyester. Geeignete Polymerblends wurden beispielsweise von Wu et al. (Journal of applied polymer science, 2006, vol. 99, no2, pp. 477-488) im Zusammenhang mit CNT beschrieben. Bei Verwendung mehrerer verschiedener Polymere kann, je nach Eigenschaft der Polymere, ein einphasiges oder mehrphasiges System entstehen.

Bevorzugterweise weisen die erfindungsgemäß verwendeten Polymere eine Schmelztemperatur in einem Bereich von 100°C bis 350°C, weiter bevorzugt in einem Bereich von 150°C bis 350°C, weiter bevorzugt in einem Bereich von 170°C bis 300°C, noch weiter bevorzugt in einem Bereich von 190°C bis 300°C, auf.

Zusätzlich bevorzugt weisen die erfindungsgemäß verwendeten Polymere eine Viskositätszahl zwischen 0,1 ml/g und 300 ml/g, bevorzugterweise zwischen 100 ml/g und 300 ml/g, weiter bevorzugt zwischen 150 ml/g und 300 ml/g auf (Bestimmung der Viskositätszahl: Dekalin, 135 °C, DIN 53 728).

Ohne an eine Theorie gebunden zu sein, wird davon ausgegangen, dass eine geringere Viskositätszahl vorteilhaft bei der thermischen Behandlung des Polymerformkörpers zur Erzeugung leitfähiger Strukturen ist, da sich die CNTs bei geringerer Viskosität der Polymerschmelze leichter in ihrer Position verändern können. Zusätzlich bevorzugt enthält die CNT-enthaltende Polymerphase Additive, bevorzugterweise Haftvermittler bzw. Kompatibilisierer. Haftvermittler bzw. Kompatibilisierer werden verwendet, um die Haftbindung zwischen Materialien, mit z.B. unterschiedlichen Polaritäten, zu unterstützen. Ein "Kompatibilisierer" ist bevorzugterweise ein thermoplastischer Kunststoff, welcher zwei andere Thermoplaste durch eine reaktive oder chemische (kovalente, Dipol-Dipol-, Ionen- oder Säure-Base-) Bindung oder durch ein nichtreaktives (Verkettungs-) Mittel miteinander verbindet. Beispiele sind mit Maleinsäureanhydrid gepfropfte Polymere oder mit Ethylenvinylacetat gepfropfte Polymere wie etwa die Produktlinien PLEXAR^{®} von Quantum Chemical, ADMER^{®} von Mitsui Petrochemical und BYNEL^{®} von DuPont, Ethylenmetylacrylat und Ionomere.

Zusätzlich bevorzugte Hilfsstoffe, die für den Polymerformkörper verwendet werden können sind Verstärkungsstoffe wie Glasfaser, Glaskugeln oder -flakes und Mineralien z.B. Talkum, Mica, Wollastonit, Kaolin, Silikate bzw. silicatische Materialien, einschließlich von Schichtsilicaten, bevorzugterweise in Mengen zwischen 1 und 50 Gew.-%, insbesondere zwischen 10 und 50 Gew.-%.

Zusätzlich bevorzugt kann der Polymerformkörper auch Flammschutzmittel, wie beispielsweise halogenhaltige, phosphorhaltige, magnesium/aluminiumhaltige Flammschutzmittel, in Mengen von bevorzugterweise 1-60 Gew.-%, insbesondere etwa 10 bis 60 Gew.-% enthalten.

Zusätzlich bevorzugt enthält der Polymerformkörper mindestens ein Treibmittel, beispielsweise das von der Firma Clariant unter dem Handelsnamen "Hydrocerol" vertriebene Treibmittel. Weitere Beispiele für Treibmittel sind Azodicarbonamide (sowie modifizierte Varianten von Azodicarbonamiden), Natriumhydrogencarbonat, und Sulfohydrazide, insbesondere 4,4'-Oxybis(benzolsulfonylhydrazide), 5-Phenyltetrazole, p-Toluylensulfonylsemicarbazide, oder p-Toluylensulfonylhydrazide. Das Treibmittel wird hierbei erfindungsgemäß vor der Formung des Polymerformkörpers, beispielsweise bei der Zugabe der CNTs zu dem Polymer, eingebracht. Es werden übliche Mengen eingesetzt, z.B. im Bereich von etwa 0,1 bis etwa 4 Gew.-%. Es ist bevorzugt, dass das Treibmittel eine Zersetzungstemperatur aufweist, die oberhalb der Verarbeitungstemperatur des Polymers bzw. der Polymermischung (bei der Herstellung des Polymerformkörpers, d.h. vor der erfindungsgemäßen thermischen Behandlung des Polymerformkörpers) liegt. Bevorzugterweise liegt die Zersetzungstemperatur des Treibmittels daher oberhalb von etwa 150°, weiter bevorzugt oberhalb von 200°C (wie beispielsweise bei Azodicarbonamid, 5-Phenyltetrazol und p-Toluylensulfonylsemicarbazid). Das Treibmittel kann je nach den gewünschten Polymeren im Polymerformkörper entsprechend so gewählt werden, dass dessen Zersetzungstemperatur über der Verarbeitungstemperatur der leweiligen gewünschten Polymere liegt. Zusätzlich ist es auch bevorzugt, dass das Polymer/die Polymermischung eine niedrige Schmelztemperatur bzw. niedrige Verarbeitungstemperatur aufweist.

Bei der Durchführung des erfindungsgemäßen Verfahrens, insbesondere durch Wärme- bzw. Laserbehandlung, wird der Polymerformkörper an definierten Stellen über die Zersetzungstemperatur der Treibmittel erwärmt. Dadurch werden Kavitäten geschafft bzw. es kommt zu einer Aufschäumung des Polymerformkörpers im Bereich der leitfähigen Strukturen. Dadurch entstehen erhabene leitfähige Strukturen, die überraschenderweise zudem noch eine verbesserte Leitfähigkeit im Vergleich zu Strukturen aufweisen, die ohne Verwendung von Treibmitteln hergestellt worden sind. Es wird hierbei angenommen, dass die CNTs durch das Treibmittel bzw. dessen Zersetzung eine günstigere Anordnung einnehmen, die eine bessere Leitfähigkeit begünstigt. Somit betrifft die vorliegende Erfindung zudem die Verwendung von Treibmitteln in Polymeren bzw. Polymerformkörpern, die zur Erzeugung von definierten (leitfähigen) Strukturen erwärmt werden.

Bevorzugt enthält die Polymerphase bzw. der Polymerformkörper mindestens einen lichtleitenden Zusatz und/oder mindestens einen wärmeleitenden Zusatz mit einer Leitfähigkeit von mehr als 20 W/mK. Der mindestens eine lichtleitende Zusatz und/oder der mindestens eine wärmeleitende Zusatz können bevorzugt jeweils mit mindestens 0,05 Gew.-%, weiter bevorzugt mindestens 0,1 Gew.-%, weiter bevorzugt mindestens 0,5 Gew.-% bezogen auf das Gesamtgewicht des Polymerformkörpers bzw. der Polymerphase enthalten sein. Bevorzugt liegt die eingesetzte Menge bei nicht mehr als etwa 70 Gew.-%, insbesondere nicht mehr als etwa 50 Gew.-%, weiter bevorzugt nicht mehr als etwa 10 Gew.-%, weiter bevorzugt nicht mehr als etwa 5 Gew.-% bezogen auf das Gesamtgewicht des Polymerformkörpers bzw. der Polymerphase . Die Verwendung dieser Materialien fördert das Eindringen von Licht/ Wärme in tiefere Schichten der Polymerphase während der erfindungsgemäßen Behandlung und führt damit zu einer Verbesserung des Schmelzvorgangs und somit zu einer Erhöhung der Leitfähigkeit aufgrund einer erhöhten CNT-Konzentration in der resultierenden Struktur. Erfindungsgemäß bevorzugte lichtleitende Zusätze sind Glasformkörper, die beispielsweise in Form von Glasfasern, -kugeln oder - flakes eingebracht werden können. Geeignete wärmeleitende Mineralien sind beispielsweise SiO₂, und Silicate. Insbesondere bevorzugt sind SiO₂ und Silicate, da dieses sowohl licht- als wärmeleitend sind. Weitere Materialien sind dem Fachmann bekannt und die Wärmeleitfähigkeit dieser Materialien kann durch Standardverfahren bestimmt werden. Es hat sich gezeigt, dass insbesondere bei Verwendung eines Lasers in dem erfindungsgemäßen Verfahren das Einbringen von licht- bzw. wärmeleitenden Zusätzen zu einer verbesserten Leitfähigkeit der erzeugten Strukturen führt. Geeignete Glasformkörper weisen beispielsweise eine Größe (maximale Ausdehnung in eine Richtung) von bis zu 50 µm, bevorzugterweise bis zu 10 µm und am meisten bevorzugt bis zu 1 µm, auf. Die Glasformkörper können, wie auch die Treibmittel, vor der Formung des Polymerformkörpers, z.B. während der Zugabe der CTNs in die noch flüssige Polymerphase eingebracht werden.

Erfindungsgemäß besteht der Polymerformkörper bevorzugt aus mindestens zwei miteinander im Wesentlichen nicht mischbaren (phasenunverträglichen) Polymeren. Werden zwei oder mehr phasenunverträgliche Polymere verwendet, so können diese selbst nach dem Anschmelzen des Polymerformkörpers ein zwei- oder mehrphasiges System ausbilden. Phasenunverträgliche Systeme sind dem Fachmann bekannt. Werden die beiden Polymersorten vermengt, liegen sie in getrennten Phasen nebeneinander vor. Wird eine derartige Mischung über einen längeren Zeitraum in der Schmelze gehalten, koaleszieren die aus jeweils einer Polymersorte gebildeten Domänen, d.h. es findet eine Phasenseparierung statt.

Beispielsweise sind Polymere, ausgewählt aus der Gruppe bestehend aus Polystyrol (PS), Polymethylmetacrylat (PMMA) und Acrylnitrit-Butadien-Styrol (ABS), sowie thermoplastischen Polyestern, wie Polyethylenterephthalat (PET) oder Polybutylenterephthalat (PBT), und Polycarbonate nicht mischbar mit Polypropylen und/oder Polypropylencopolymeren. Des Weiteren sind Polystyrol und Polyamid-6 nicht mit Polyethylen oder Polypropylen mischbar. Kombinationen aus zwei oder mehr der vorstehend genannten Polymere sind erfindungsgemäß bevorzugt, wobei die Verwendung von Polycarbonat in Kombination mit Polypropylen besonders bevorzugt ist.

Bei Verwendung von Polypropylen und/oder einem Polypropylencopolymer in einem Gemisch mit dazu phasenunverträglichen Polymeren ist es bevorzugt, jeweils bezogen auf die gesamte Masse des Polymergemisches (inklusive der eventuell verwendeten Hilfsstoffe und Carbon Nanotubes), mindestens 40 Gew.-%, weiter bevorzugt mindestens 60 Gew.-%, noch weiter bevorzugt mindestens 80 Gew.-%, weiter bevorzugt mindestens 90 Gew.-%, und am meisten bevorzugt mindestens 99 Gew.-%, Polypropylen und/oder Polypropylencopolymer zu verwenden. Weitere bevorzugte Mengenbereich sind: 40 bis 99 Gew.-%, weiter bevorzugt 60 bis 95 Gew.-%, noch weiter bevorzugt 70 bis 95 Gew.-%, Polypropylen und/oder Polypropylencopolymer.

Carbon Nanotubes (CNT), auch Kohlenstoffnanoröhrchen oder Kohlenstoffnanotubes genannt, sind aus Kohlenstoffatomen in bestimmter molekularer Anordnung ausgebildete, faserartige Strukturen. CNT bestehen aus Wandabschnitten, die Hohlräume umschließen. Die Wände sind hierbei aus Kohlenstoffatomen mit jeweils drei Bindungspartnern aufgebaut, die eine wabenartige Struktur aus Sechsecken bilden. Je nach Anordnung der Wandstrukturen spricht man von einlagigen Kohlenstoffnanotubes (single wall carbon nanotubes, SWCNT), die aus einzelnen Röhren aufgebaut sind und einen Innendurchmesser von 1-3 nm aufweisen, oder von mehrlagigen Kohlenstoffnanotubes (multi wall carbon nanotubes, MWCNT), die aus mehreren konzentrisch ineinander geschachtelten Röhren bestehen. Die Außendurchmesser der Carbon Nanotubes betragen zwischen 1 nm und 400 nm, wobei Carbon Nanotubes mit einem Außendurchmesser zwischen 10 und 400 nm häufig als Kohlenstoffnanofaser (Carbon Nano Fibre, CNF) bezeichnet werden.

Die Herstellung von Carbon Nanotubes ist dem Fachmann bekannt und kann beispielsweise im Lichtbogenverfahren (Iijima, Nature 354, 1991, 56-8) oder mittels Abscheideverfahren aus der Gasphase (Chemical Vapor Deposition, CVD) erfolgen (P. M. Ajayan, Nanotubes from Carbon, Chem. Rev. 99, S. 1787-1799, 1999). Ein weiteres Verfahren ist in der WO 99/13127, DE 19946182 und WO 98/39250 beschrieben. Hierbei dienen gepulste Laser zur Verdampfung von kohlenstoffhaltigen Materialien, die in einer Vakuumkammer angeordnet sind. Ein Teil der verdampften Kohlenstoffmoleküle kondensiert auf sogenannten Auffängern, deren Temperatur durch externe Heizung und Kühlung gesteuert wird wodurch das Wachstum von Nanoröhren bewirkt wird. Weitere Herstellungsmethoden umfassen beispielsweise Lichtbogen-, Laserablations und katalytische Verfahren. WO 86/03455 und WO 2006/050903 beschreiben Herstellungsverfahren, worin aliphatische oder aromatische Kohlenwasserstoffe in Gegenwart eines Eisen enthaltenden Katalysators bei Temperaturen von 800-900°C zersetzt werden. Bei den bekannten Verfahren werden oft Ruß, amorpher Kohlenstoff und Fasern mit hohen Durchmessern als Nebenprodukte gebildet. Bei der katalytische Abscheidung von Kohlenstoff aus gasförmigen Kohlenwasserstoffen (Catalytic Carbon Vapour Deposition) können beispielsweise Acetylen, Methan, Ethan, Ethylen, Butan, Buten, Butadien, oder Benzol verwendet werden. Als Katalysatoren können z.B. Metalle wie Fe oder Ni oder auch Metalloxide verwendet werden. Die unter Verwendung der vorstehenden Verfahren hergestellten Carbon Nanotubes fallen meist als CNT-Pulver an und können direkt mit den Polymeren vermischt werden.

Erfindungsgemäß werden bevorzugt CNT mit einem mittleren Durchmesser von 2 bis 100 nm, weiter bevorzugt 5 bis 80 nm, und besonders bevorzugt 6 bis 50 nm verwendet. Bevorzugt werden MWCNT verwendet. Des Weiteren ist dem Fachmann bekannt, dass die Carbon Nanotubes je nach Symmetrie bzw. Anordnung der Kohlenstoffsechsecke in den Röhrenwänden unterschiedliche Elektronenzustände aufweisen und somit Eigenschaften von Metallen oder Halbleitern aufweisen können. Je nach Anwendung wird der Fachmann daher die geeigneten, in der Literatur beschriebenen, Carbon Nanotubes auswählen können. Erfindungsgemäß können auch "funktionalisierte Carbon Nanotubes" verwendet werden, solange diese Carbon Nanotubes sich nicht derart mit den Polymeren verbinden, dass eine Migration verhindert wird. "funktionalisierte Carbon Nanotubes" weisen eine modifizierte Oberfläche auf und sind beispielsweise in US 6,203,814 und US 08/812,856 beschrieben.

Anstelle von oder zusätzlich zu den Carbon Nanotubes können nach einer möglichen erfindungsgemäßen Ausführungsform auch Graphene anstelle der CNTs oder zusammen mit diesen eingesetzt werden. Graphene und Verfahren zu deren Herstellung sind dem Fachmann bekannt. Graphene sind einatomare Graphitschichten, die beispielsweise durch epitaktisches Aufwachsen auf einem Siliziumoxid-Substrat hergestellt werden können. CNTs sind erfindungsgemäß jedoch bevorzugt.

Erfindungsgemäß bevorzugt werden Carbon Nanotubes in einem Mengenanteil (bezogen auf die Gesamtmasse der Polymerphase/n des Polymerformkörpers) verwendet, so dass der Polymerformkörper ohne die erfindungsgemäßen leitfähigen Strukturen nicht oder nur gering leitfähig ist. Bei reinen Polycarbonatwerkstoffen können daher beispielsweise insgesamt nur weniger als etwa 5 Gew.-% an CNT eingesetzt werden. Für Polypropylen können maximal etwa 8 - 10 Gew.-% CNT verwendet werden. Ein Fachmann wird je nach Anwendung des erfindungsgemäßen Polymerformkörpers die geeignete Gesamtmenge an CNT durch Testversuche bestimmen.

Zusätzlich bevorzugt können im erfindungsgemäßen Verfahren bzw. in den erfindungsgemäßen Polymerformkörpern Nanocomposits verwendet werden. Derartige Stoffe und deren Anwendung sind dem Fachmann bekannt und beispielsweise in der EP 1 776 418 beschrieben. Bevorzugt werden hierbei Nano-Schichtsilikate, wie beispielsweise Aluminiumschichtsilikat, verwendet. Bevorzugterweise werden Nanocomposits in einem Anteil, bezogen auf die Gesamtmasse der Polymerphase/n im Polymerformkörper, von 0,1 bis 10 Gew.-%, vorzugsweise von 0,5 bis 5 Gew.-%, insbesondere bevorzugt von 0,5 bis 2 Gew.-% eingesetzt.

Zusätzlich bevorzugt kann/können die Polymerphase/n des Polymerformkörpers weitere Stoffe enthalten, die die elektrische Leitfähigkeit des Polymerformkörpers erhöhen können. Beispielsweise können metallbeschichtete Carbonfaser oder ähnliches enthalten sein.

Zusätzlich bevorzugt enthält der Polymerformkörper außer polymeren Bestandteilen, CNT und Nanocomposits maximal 20 Gew.-%, weiter bevorzugt maximal 10 Gew.-%, an weiteren Stoffen wie Verarbeitungshilfsmittel, Dispergierhilfsmittel, Haft- und Verträglichkeitsvermittler, Licht- und Alterungsschutzmittel, Farbstoffe etc.

Der Ausdruck "elektrisch leitfähig", so wie hier verwendet, bezeichnet einen Körper mit einem Oberflächenwiderstand von weniger als 10⁹, bevorzugt weniger als 10⁷ Ohm, weiter bevorzugt weniger als 10⁵, und besonders bevorzugt weniger als 10⁴ Ohm. Dementsprechend betreffen die Ausdrücke "nicht elektrisch leitfähig" und "gering elektrisch leitfähig", so wie hier verwendet, einen Körper mit einem Oberflächenwiderstand von mehr als 10⁹ Ohm, bevorzugt mehr als 10⁷ Ohm, weiter bevorzugt mehr als 10⁵, und besonders bevorzugt mehr als 10⁴ Ohm. Durch das erfindungsgemäße Verfahren ist es möglich, den Oberflächenwiderstand in definierten Bereichen um den Faktor 10, insbesondere 100, insbesondere 1000 oder mehr zu verringern, um elektrisch leitfähige Strukturen zu erzeugen.

Eine elektrisch leitfähige Struktur im Sinne der vorliegenden Erfindung ist eine geometrische Anordnung von elektrisch leitfähigen Bereichen auf der Oberfläche eines Polymerformkörpers, wobei die elektrisch leitfähigen Bereiche an elektrisch nicht leitfähige Bereiche auf der Oberfläche angrenzen. Wie oben beschrieben, bestehen die nicht leitfähigen Bereich ebenfalls aus polymeren Bestandteilen, die CNTs aufweisen. Insbesondere können die elektrisch leitfähigen Strukturen für elektronische Anwendungen ausgebildet sein. Die elektrisch leitfähigen Strukturen können daher beliebige geometrische Formen aufweisen, insbesondere die Form von Linien, Flächen oder Mustern, vorzugsweise immer abgegrenzt durch nicht behandelte (und somit nicht elektrisch leitfähige) Bereiche. Im Gegensatz zu bekannten leitfähigen Strukturen aus CNT enthaltenden Materialien wird erfindungsgemäß bevorzugt eine CNT enthaltende Schicht so umgewandelt, dass leitfähige und nicht leitfähige Bereiche entstehen. Es werden jedoch nicht einfach leitfähige Bereiche auf eine Oberfläche aufgebracht. Genausowenig werden nicht leitfähige Bereiche von der Oberfläche entfernt (z.B. durch Abdampfen), sodass nur leitfähige Strukturen verbleiben. Somit ist das erfindungsgemäße Verfahren dazu geeignet, die Oberfläche der CNT-enthaltenden Polymerphase gezielt in leitfähige Strukturen umzuwandeln. Das erfindungsgemäße Verfahren kann einfacher durchgeführt werden als die bekannten Verfahren (z.B. als das Verfahren aus US 2006/0062983) und ermöglicht die Bildung von kleineren Strukturen. Zudem führt das erfindungsgemäße Verfahren, aufgrund der Konzentrierung der CNTs an der Oberfläche, zu einer höheren Leitfähigkeit als die der Polymerschichten, die die gleiche CNT-Konzentration wie die erfindungsgemäße Polymerphase aufweisen und mit bekannten Verfahren auf ein Substrat aufgebracht werden.

Zusätzlich zu der elektrischen Leitfähigkeit erhöht sich auch die thermische Leitfähigkeit der thermisch behandelten Bereiche der Oberfläche des Polymerformkörpers. Dies ermöglicht weitere technische Anwendungsmöglichkeiten.

Das erfindungsgemäße Verfahren umfasst in einem ersten Schritt das Bereitstellen eines Polymerformkörpers aus mindestens einer Polymerphase, die Carbon Nanotubes (CNT) enthält, wobei der Polymerformkörper eine Polyolefin-Beimischung von mindestens 10 Gew.% bezogen auf das Gewicht des Polymerformkörpers umfasst.

Hierbei wird/werden ein oder mehrere der oben aufgeführten Polymere, unter Schmelzen der Polymere, mit den Carbon Nanotubes vermischt. Die Vermischung der einzelnen Bestandteile kann in an sich beliebiger Weise erfolgen. Bekannte Verfahren zur Herstellung von Polymeren mit CNT bestehen darin, das synthetisierte Polymer, welches regelmäßig als Granulat, Pulver oder auch in Blockform vorliegt, durch Wärmezufuhr aufzuschmelzen und so in einen flüssig-viskosen Zustand zu überführen. Dadurch kann die Viskosität des Polymers abgesenkt, und die CNT in das Polymer eingemischt werden. Ein solches Verfahren kann der US 4,157,325 entnommen werden. Aus der kanadischen Offenlegungsschrift CA 2,324,353 A1 ist bekannt, Füllstoffe in ein Monomer einzumischen, eine in-situ-Polymerisation zu starten und den so synthetisierten Thermoplast nachfolgend aufzuschmelzen, um weitere Füllstoffe darin einzubringen. Hierbei können die Carbon Nanotubes vor oder während dem Schmelzvorgang zugegeben werden.

Zum Einmischen von Stoffen in niederviskose Kunststoffvorprodukte können beispielsweise die bekannten Dispergierverfahren unter Verwendung einer Perlmühle, Ultraschallsonde, einem Dreirollenwalzwerk oder einem Hochdruckdispergator eingesetzt werden. Zum Einmischen in hochviskose Kunststoffschmelzen finden die bekannten Verfahren wie z.B. der Einsatz von gleichlaufenden Doppelschneckenextrudern z.B. von der Fa. Coperion (DE) oder Fa. Leistritz (DE), von gegenläufigen Doppelschneckenextrudern Fa. Pomini (IT) und Fa. Farell (US) oder der von der Fa. Buss (CH) hergestellte Ko-Kneter Verwendung.

Diese Verfahren können auch eingesetzt werden, wenn phasenunverträgliche Polymere verwendet werden. Beispielsweise können Polypropylen und/oder Polypropylencopolymer mit phasenunverträglichen Polymeren auf diese Weise vermischt und dann gemeinsam aufgeschmolzen und vermengt werden. Bei Verwendung von Nanocomposits können diese ebenfalls vor oder während dem Aufschmelzen zugegeben werden.

Bevorzugterweise wird/werden die Polymerphase/n durch Vermischen von geschmolzenem Polymer mit 0,1-10 Gew.-% Carbon Nanotubes, bezogen auf die Gesamtmasse der Polymerphase/n des Polymerformkörpers, hergestellt.

Zudem ist es möglich, das Vermischen aller Bestandteile in mehreren, aufeinander folgenden Arbeitsschritten durchzuführen. Beispielsweise kann zunächst ein Polymer mit den Carbon Nanotubes unter Schmelzen vermischt und das so erhaltene Masterbatch in einem nachfolgenden Schritt, beispielsweise nach dem Abkühlen und Granulieren, mit den übrigen Polymeren vermischt und geschmolzen werden. Die Herstellung derartiger Masterbatches ist z.B. in US 5,643,502 beschrieben. Durch den Einsatz derartiger Masterbatches kann die Verteilung der Carbon Nanotubes in der Kunststoffmasse verbessert werden.

Hierbei ist es zusätzlich bevorzugt, dass der Polymerformkörper durch Verschmelzen mindestens einer Polymerphase, die Carbon Nanotubes (CNT) in einem Anteil (bezogen auf die Polymerphase) zwischen 1 und 40 Gew.-%, weiter bevorzugt zwischen 5 und 30 Gew.-%, weiter bevorzugt 15 und 30 Gew.-%, enthält, mit mindestens einer weiteren Polymerphase mit geringerem Carbon Nanotubes (CNT)-Anteil, erhalten wird. Hierbei sollte der Gesamtgehalt an CNT dennoch nicht so hoch sein, dass der Polymerformkörper bereits ohne die erfindungsgemäßen leitfähigen Strukturen leitfähig ist. Die Polymerphasen mit unterschiedlichen Carbon Nanotubes (CNT)-Anteilen können hierbei, wie oben beschrieben, unter Verschmelzen der Polymere oder Polymergemische mit den Carbon Nanotubes erhalten werden. Weiter bevorzugt wird die Polymerphase mit dem höheren Carbon Nanotubes-Anteil in geringeren Gewichtsanteilen als die Polymerphasen mit niedrigeren Carbon Nanotubes-Anteilen verwendet. Bevorzugt weisen die Polymerphasen mit niedrigeren Carbon Nanotubes-Anteilen zwischen 0 und 10 Gew.-% CNT (bezogen auf die Polymerphase), weiter bevorzugt zwischen 0 und 5 Gew.-% CNT, auf. Bevorzugterweise wird die Polymerphase mit dem höheren Carbon Nanotubes-Anteil in einem Anteil zwischen 0,5 und 40 Gew.-%, weiter bevorzugt zwischen 1 und 40 Gew.-%, weiter bevorzugt zwischen 1 und 30 Gew.-%, weiter bevorzugt zwischen 1 und 20 Gew.-%, und am meisten bevorzugt zwischen 1 und 10 Gew.-%, bezogen auf die Gesamtmasse der Polymerphasen des Polymerformkörpers, enthalten sein.

Es hat sich überraschenderweise gezeigt, dass die Verwendung von zwei phasenunverträglichen Polymerphasen, von denen eine Polymerphase einen hohen Carbon Nanotubes-Anteil aufweist, eine besonders hohe Leitfähigkeit der erzeugten Strukturen ermöglicht. Es hat sich hierbei gezeigt, dass die Polymerphasen auch nach dem Schmelzen (bei der Herstellung des Polymerformkörpers) noch unterschiedliche Carbon Nanotubes-Anteile aufweisen. Im Gegensatz dazu führt die bekannte Verwendung von Masterbatches mit erhöhtem Ruß-Anteil, beispielsweise bei Verfahren zur Einfärbung von Polymerformkörpern, zu einer gleichmäßigen Verteilung der Rußpartikel auf die Polymerphasen.

Weiter bevorzugt wird hierbei die Polymerphase, die Carbon Nanotubes (CNT) in einem höheren Anteil enthält, aus einem oder mehreren Polymeren, ausgewählt aus der Gruppe bestehend aus Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA6.4), Polyamid 12 (PA 12), aromatischem Polyamid, Polysulfon, hergestellt. Bevorzugterweise besteht diese Polymerphase zu mindestens 50 Gew.-%, weiter bevorzugt zu mindestens 60 Gew.-%, weiter bevorzugt zu mindestens 70 Gew.-%, noch weiter bevorzugt zu mindestens 80 Gew.-%, und am meisten bevorzugt zu mindestens 90 Gew.-% aus Polycarbonat.

Die gewünschten Polymerformkörper können dann auf übliche Weise durch Extrusions- oder Spritzgussverfahren aus den Polymergemischen erhalten werden.

In einem zweiten Schritt des erfindungsgemäßen Verfahrens erfolgt eine thermische Behandlung mindestens einer Oberfläche des Polymerformkörpers zur Erzeugung der leitfähigen, insbesondere der elektrisch leitfähigen, Strukturen auf der Oberfläche des Polymerformkörpers, wobei die thermische Behandlung das Erhitzen des Bereichs der Oberfläche auf eine Temperatur umfasst, die mindestens der Schmelztemperatur der mindestens einen Polymerphase entspricht. Nach einer bevorzugten Ausführungsform erfolgt nach dem Abkühlen der thermisch behandelten Bereiche (bis sich die Polymerphasen wieder verfestigt haben), eine (oder auch mehrere) weitere thermische Behandlung derselben Bereiche.

Bevorzugterweise erfolgt die thermische Behandlung der Oberfläche/n des Polymerformkörpers durch Kontakt mit einem erhitzten Körper, Gas (z.B. Heißluft) oder Flüssigkeit, oder durch elektromagnetische Strahlung oder unter Verwendung des Geräts (das unten beschrieben wird). Ein Fachmann kann das jeweils geeignete Mittel auswählen, um einen definierten Bereich der Oberfläche anzuschmelzen.

Hierbei ist es möglich, die thermische Behandlung entweder nach vorhergehender Erzeugung des Polymerformkörpers, d.h. nachdem der Polymerformkörper das "Formwerkzeug" verlassen hat, oder bereits bei der Herstellung eines solchen Formkörpers im Formwerkzeug, durchzuführen. Es sind bereits Werkzeuge bekannt, bei denen einzelne Teile eines Formkörpers im Werkzeug gezielt erhitzt oder länger heiß gehalten werden können.

Bevorzugterweise wird jedoch elektromagnetische Strahlung zur thermischen Behandlung der Oberfläche des Polymerformkörpers verwendet. Weiter bevorzugt ist es hierbei, Laserstrahlung oder IR-Strahlung, weiter bevorzugt Laserstrahlung, zu verwenden. Hierbei können bekannte Lithographieverfahren zur gezielten Bestrahlung von definierten Bereichen von Substratoberflächen eingesetzt werden. Verfahren zur gezielten Bestrahlung von Oberflächen sind dem Fachmann bekannt und beispielsweise in der EP 0 847 329 A oder WO 02/079881 A offenbart. Besonders bevorzugt ist die Verwendung eines pulsierenden Lasers. Insbesondere die Verwendung von pulsierender Laserstrahlung führte überraschenderweise zu einer noch weiter verbesserten Leitfähigkeit.

Geeignete Laser für das erfindungsgemäße Verfahren sind: He-Ne-Laser, Nd:YAG-Laser, Kohlendioxidlaser (CO₂-Laser), Kohlenmonoxidlaser (CO-Laser), Stickstofflaser (N₂-Laser), ArgonIonen-Laser, Helium-Cadmium-Laser (HeCd-Laser), Krypton-Ionen-Laser, Sauerstoff-Ionen-Laser, Xenon-Ionen-Laser, Mischgas-Laser (beispielsweise mit Argon und Krypton), Excimerlaser, Metalldampflaser (beispielsweise Kupferdampflaser) und Metallhalogenid-Laser (beispielsweise Kupferbromid-Laser), bevorzugt sind Kohlendioxidlaser (CO₂-Laser) und Nd:YAG-Laser.

Bevorzugterweise wird eine Stelle der Oberfläche des Polymerformkörpers für 0,001 bis 1 Sekunde erhitzt. Die Zeitdauer des Erhitzens bezieht sich hierbei auf die Zeitdauer, in der sich die Oberfläche des Polymerformkörpers in geschmolzenem Zustand befindet. Diese Zeitdauer kann vom Fachmann für die gewünschte Anwendung und die verwendeten Polymere leicht gewählt werden. Insbesondere ist es möglich, durch die Zeitdauer des Erhitzens, in der die Oberfläche angeschmolzen ist, den Oberflächenwiderstand einzustellen. Je länger die Oberfläche angeschmolzen wird und umso tiefer sich der angeschmolzene Bereich in die Oberfläche hinein erstreckt, desto mehr Carbon Nanotubes migrieren an die Oberfläche, wodurch die elektrische Leitfähigkeit der Struktur erhöht wird.

Der Ausdruck "Oberfläche", so wie hier verwendet, bezieht sich auf eine Oberfläche eines Polymerformkörpers, insbesondere auf die Oberfläche der Polymerphase des Polymerformkörpers, die CNTs enthält. Entscheidend für die vorliegende Erfindung ist, dass die Leitfähigkeit der Oberfläche eines Polymerformkörpers, durch Behandlung der Oberfläche der Polymerphase die CNTs enthält, erhöht wird. In einer Ausführungsform der Erfindung kann beispielsweise eine Schicht aus einem Polymer, die CNTs enthält, auf einen Körper aufgetragen werden und die gesamte Polymerschicht (gesamte Oberfläche der Polymerphase) erfindungsgemäß behandelt werden. Es verbleibt somit keine unbehandelte Oberfläche der CNT-enthaltenden Polymerphase. Die so erhaltene leitfähige Schicht unterscheidet sich von einer leitfähigen, CNT-enthaltenden Polymerschicht die auf einen Polymerformkörper aufgetragen wird (beispielsweise durch ein Beschichtungsverfahren wie in US 2006/0062983 A1 beschrieben). Durch die erfindungsgemäße Behandlung der Oberfläche der Polymerphase liegt eine höhere CNT-Konzentration der Polymerphase an der Oberfläche vor, während die Konzentration an CNTs mit größer werdendem Abstand zur Oberfläche im Inneren der Polymerphase abnimmt. Bevorzugterweise weist somit die Oberfläche der Polymerphase, die der behandelten Oberfläche der Polymerphase gegenüberliegt (z.B. die Seite der Polymerschicht die mit dem Körper verbunden ist) eine geringere CNT-Konzentration auf.

In einer anderen Ausführungsform der Erfindung werden nur bestimmte Bereiche einer Oberfläche der Polymerphase erfindungsgemäß behandelt, wobei dann die CNT-Konzentration der benachbarten, unbehandelten Bereiche der gleichen Oberfläche eine nahezu unveränderte CNT-Konzentration beibehalten.

Es ist zusätzlich bevorzugt, dass die Oberfläche des Polymerformkörpers auf eine Temperatur erhitzt wird, die zum Schmelzen der Polymerphase/n ausreicht, jedoch nicht zu einem merklichen Verdampfen der Polymerphase/n führt. Der Ausdruck "merkliches Verdampfen" bedeutet hierbei, dass die erzeugte leitfähige Struktur weniger als 1 Mikrometer, weiter bevorzugt weniger als 500 nm, tief in der Oberfläche des Polymerformkörpers liegt.

Das erfindungsgemäße Verfahren kann insbesondere zur Herstellung von elektronischen Schaltkreisen auf der Oberfläche des Polymerformkörpers verwendet werden. Somit können auf einfache Weise insbesondere sehr kleine Bauteile, beispielsweise als MIDs (moulded interconnected devices) hergestellt werden. Hierbei werden die Polymerformkörper erfindungsgemäß beispielsweise in einem Standard-Spritzgießverfahren als beliebige Formteile hergestellt und anschließend die elektrisch leitfähigen Strukturen erzeugt.

Des Weiteren betrifft die Erfindung einen Polymerformkörper gemäß Anspruch 6. Der Polymerformkörper umfasst nach einer Ausführungsform mindestens eine Polymerphase und zwischen 0,01 und 10 Gew.-%, bevorzugt zwischen 0,1 und 10 Gew.-%, weiter bevorzugt zwischen 0,1 und 10 Gew.-%, weiter bevorzugt zwischen 0,1 und 8 Gew.-%, und am meisten bevorzugt zwischen 0,1 und 6 Gew.-%. Carbon Nanotubes (CNT) (bezogen auf die Gesamtmasse der Polymerphase/n des Polymerformkörpers), wobei der Polymerformkörper auf der Oberfläche elektrisch oder thermisch, bevorzugt elektrisch, leitfähige Strukturen aufweist, wobei die Konzentration der CNT in den Bereichen der leitfähigen Oberflächenstrukturen höher ist als in den nicht leitfähigen Oberflächenbereichen. Wie oben beschrieben, weisen die nicht leitfähigen Oberflächenbereiche der CNT-enthaltenden Polymerphase ebenfalls CNTs auf. Bevorzugt weisen die nicht leitfähigen Oberflächenbereiche die gleiche CNT-Konzentration wie vor der Erzeugung der leitfähigen Strukturen auf, bevorzugt also die erfindungsgemäß verwendeten Konzentrationen an CNT (siehe oben), beispielsweise 0,01 bis 10 Gew.-% CNT.

Bevorzugterweise besteht der Polymerformkörper aus den im Vorangegangenen beschriebenen, insbesondere als bevorzugt erwähnten, Polymeren, wobei der Polymerformkörper eine Polyolefin-Beimischung von mindestens 10 Gew.-% bezogen auf das Gewicht des Polymerformkörpers umfasst. Insbesondere bevorzugt enthält der Polymerformkörper mindestens eine Polymerphase die ein Polymer enthält, ausgewählt aus der Gruppe bestehend aus: Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA6.4), Polyamid 12 (PA 12), aromatischem Polyamid und Polysulfon, Polypropylen.

Zusätzlich bevorzugt enthält der Polymerformkörper Nanocomposits. Geeignete Nanocomposits und geeignete Mengen wurden im Vorangegangenen beschrieben.

In einer weiteren bevorzugten Ausführungsform der Erfindung weist der Polymerformkörper mindestens zwei getrennte Polymerphasen auf. Besonders bevorzugt enthält der Polymerformkörper mindestens zwei, weiter bevorzugt zwei, Polymerphasen, wobei die eine Polymerphase aus Polymeren besteht, ausgewählt aus der Gruppe bestehend aus Polystyrol (PS), Polymethylmetacrylat (PMMA) und Acrylnitrit-Butadien-Styrol (ABS), sowie thermoplastischen Polyestern, wie Polyethylenterephthalat (PET) oder Polybutylenterephthalat (PBT), und Polycarbonat, sowie Mischungen daraus. Die zweite Polymerphase besteht aus Polypropylen und/oder Polypropylencopolymeren. Alternativ dazu können die beiden Polymerphasen aus Polystyrol und/oder Polyamid-6 in Kombination mit Polyethylen und/oder Polypropylen bestehen. Besonders bevorzugt ist die Verwendung von Polycarbonat in Kombination mit Polyolefinen, insbesondere Polypropylen. Die bevorzugten Mengenanteile der Polypropylen und/oder Polypropylencopolymere sind im Vorangegangenen beschrieben.

Die Analyse des fertig gestellten Polymerformkörpers hinsichtlich der vorhandenen Polymerphase/n ist im Methodenteil beschrieben. Die leitfähigen Strukturen (mit erhöhtem CNT Anteil) auf der Oberfläche des Polymerformkörpers können, wie bereits erwähnt, mit üblichen optischen Messmethoden nachgewiesen werden. Weiter bevorzugt enthält eine der Polymerphasen einen höheren Anteil an Carbon Nanotubes (CNT) als die andere/n Phasen.

Es ist zudem bevorzugt, dass die elektrisch leitfähigen Strukturen des Polymerformkörpers maximal bis 10 µm, bevorzugt maximal bis 1 µm, weiter bevorzugt maximal bis 100 nm in das Innere des Polymerformkörpers (von der äußeren Oberfläche an gerechnet) hineinreichen.

In einer besonders bevorzugten Ausführungsform der Erfindung enthält der Polymerformkörper eine Polypropylenphase und eine Polycarbonatphase, wobei bevorzugterweise zwischen 50 und 80 Gew.-%, weiter bevorzugt zwischen 60 und 80 Gew.-%, und noch weiter bevorzugt zwischen 70 und 80 Gew.-% Polypropylen, bezogen auf die gesamte Masse des Polymergemisches, verwendet werden. Besonders geeignete Polycarbonate können, wie beispielsweise in DE 13 002 66 oder DE 14 957 30 beschrieben, hergestellt werden.

Der erfindungsgemäße Polymerformkörper kann insbesondere so ausgestaltet sein, dass dessen elektrisch leitfähigen Oberflächenstrukturen Leiterbahnen bzw. elektronische Schaltkreise darstellen. Damit kann der Polymerformkörper als Platine oder Leiterplatte in einem elektronischen Bauteil oder Gerät verwendet werden. So betrifft ein erfindungsgemäßer Aspekt eine Leiterplatten-Anordnung gemäß Anspruch 9 und ein weiterer erfindungsgemäßer Aspekt ein Verfahren zur Herstellung einer Leiterplatten-Anordnung gemäß Anspruch 11. Auf diese Platine oder Leiterplatte können nach herkömmlichen Verfahren, wie beispielsweise Löten, Verkleben, Verkleben, gefolgt von einem Verlöten, Schweißen oder Ultraschall-Schweißen, beliebige Bauteile oder (elektronische) Bauelemente aufgebracht werden. Auch kann eine Anbringung durch eine dem Fachmann bekannte Bestückungsvorgehensweise, z.B. über einen Durchkontaktierungsvorgang erfolgen. Insbesondere können Löcher bzw. Bohrungen in der Leiterplatte erzeugt werden, durch welche die Bauelemente durchgeführt und anschließend auf der Leiterplatte, insbesondere der "Rückseite" der Leiterplatte, angebracht, beispielsweise verklebt oder verlötet werden. Erfindungsgemäß werden die Bauelemente auf den Leiterplatten in Kontakt mit den elektrisch leitfähigen Strukturen gebracht, wobei die elektrisch leitfähigen Strukturen, wie oben beschrieben, Bereiche mit erhöhter CNT Konzentration darstellen, die zusätzlich bevorzugt auch eine metallische Schicht, bevorzugt eine Kupferschicht, aufweisen.

Eine besonders vorteilhafte erfindungsgemäße Möglichkeit zur An- bzw. Aufbringung von Bauteilen auf den erfindungsgemäßen Polymerformkörpern wird hierin noch näher erläutert. Kurz gesagt, wird dabei der Bereich des Polymerformkörpers, in dem das Bauteil an- bzw. aufgebracht werden soll, direkt oder indirekt angeschmolzen oder aufgeschmolzen, sodass eine Anheftung des Bauteils ermöglicht wird. Es wurde überraschend gefunden, dass dadurch gleichzeitig eine sehr gut leitfähige Verbindung zwischen dem Bauteil und dem Polymerformkörper ermöglicht wird.

Ein weiterer Aspekt der Erfindung betrifft die Verwendung eines Geräts gemäß Anspruch 16 zur oben beschriebenen thermischen Behandlung mindestens einer Oberfläche des Polymerformkörpers zur Erzeugung der leitfähigen, insbesondere der elektrisch leitfähigen, Strukturen auf der Oberfläche des Polymerformkörpers.

Dieses Gerät zum Erzeugen einer Struktur an einem zu bearbeitenden Körper weist eine Energiequelle auf. Die Energiequelle weist mindestens eine Elektrode auf, über die Energie abgegeben werden kann. Diese abgegebene Energie erwärmt zumindest teilweise den zu bearbeitenden Körper und ermöglicht das oben beschriebene Aufschmelzen des Polymerformkörpers, um die gewünschten leitfähigen Strukturen zu erzeugen.

Die Erfindung ist besonders geeignet, wenn der Körper ein Polymerformkörper aus mindestens einer Polymerphase ist, die Carbon-Nanotubes enthält, da in diesem Körper durch Anlegen einer Energie an ganz spezifischen Positionen die Leitfähigkeit verändert werden kann. Somit lassen sich Leiterbahnen auf einem zu bearbeitenden Körper ohne Aufbringen einer leitfähigen Materialschicht und anschließendem Wegätzen der nicht-benötigten Bereiche der leitfähigen Materialschicht herstellen. Auf diese Weise werden Arbeitsschritte eingespart, die Produktion der Leiterplatte beschleunigt und so die Wirtschaftlichkeit der Produktion erhöht.

Der zu bearbeitende Körper lässt sich besonders effektiv erzeugen, wenn die Energiequelle mindestens zwei Elektroden aufweist, die an den zu bearbeitenden Körper anlegbar sind, wobei mit den zwei Elektroden ein Strom durch den zu bearbeitenden Körper leitbar ist bzw. eine Spannung anlegbar ist, der den zu bearbeitenden Körper aufwärmt und, wie weiter unten näher beschrieben, vorzugsweise in definierten Bereichen z.B. an der Oberfläche aufgeschmolzen. Durch diese einfache technische Maßnahme lassen sich am zu bearbeitenden Körper nach einer möglichen Ausführungsform auch dreidimensionale Strukturen erstellen, da die beiden Elektroden beispielsweise an der Vorderseite und an der Rückseite des zu bearbeitenden Körpers anlegbar sind. Beispielsweise lassen sich so auf einfache Weise Löcher in den zu bearbeitenden Körper einbrennen oder, im Falle der zuvor beschriebenen Leiterplatte, Kontaktierungen zwischen zwei Ebenen herstellen. Somit lassen sich mit dem Gerät der vorliegenden Erfindung kostengünstig Multilayer-Leiterplatten herstellen.

Zum Herstellen einfacher Leiterbahnen in einer Ebene des zu bearbeitenden Körpers kann eine Elektrode der Energiequelle an einem Punkt fixiert werden, wobei die andere Elektrode auf dem Körper beliebig bewegt wird, wodurch insbesondere im Falle einer Leiterplatte die elektrischen Leiterbahnen erzeugt werden. Alternativ können aber auch beide oder mehrere Elektroden gleichzeitig bewegt werden. Nach einer weiteren Ausführungsform der Erfindung können die beiden Elektroden auch mit einem Abstandshalter auf einem vorbestimmten Abstand zueinander gehalten werden, so dass beide Elektroden gemeinsam über den zu bearbeitenden Körper bei der Erzeugung der Struktur bewegt werden. Die Elektroden bzw. die dem Polymerformkörper zugewandten Teile davon, z.B. in Stiftform, können grundsätzlich jede beliebige Form aufweisen, wobei die Form in Hinblick auf die Form der gewünschten zu erzeugenden Leiterbahnen vom Fachmann frei wählbar ist. Auch die angelegte Spannung bzw. der Strom können frei gewählt werden, wobei der Fachmann in Abhängigkeit von dem verwendeten Polymerformkörper, dessen Zusammensetzung sowie dem Grad und Bereich der gewünschten Erwärmung des Formkörpermaterials die geeigneten Werte einfach empirisch ermitteln kann. In vielen Fällen wird z.B. eine Spannung von mehr als 500 V, insbesondere von 1000 V oder mehr günstig sein.

Nach einer bevorzugten erfindungsgemäßen Ausführungsform wird eine erste Elektrode in einem ersten Bereich des Polymerformkörpers (bzw. seiner Oberfläche) an dem bereits eine Leitfähigkeit besteht bzw. erzeugt wurde, angelegt, während eine zweite Elektrode ausgehend von einem Punkt auf dem Polymerformkörpers (bzw. seiner Oberfläche), der in dem gleichen leitfähigen Bereich liegt, oder der mit diesem Bereich über einen leitfähigen Bereich (z.B. eine Leiterbahn) verbunden ist, über den Polymerformkörpers (bzw. seiner Oberfläche) bewegt, um eine (neue) Leiterbahn zu erzeugen, den leitfähigen Bereich zu vergrößern oder zwei bestehende leitfähige Bereiche (z.B. Leiterbahnen) zu verbinden. Diese Vorgehensweise ermöglicht eine große Flexibilität bei der Erzeugung bzw. Gestaltung der leitfähigen Strukturen auf dem Polymerformkörper.

Das erfindungsgemäß verwendete Gerät kann nach einer möglichen Ausführungsform besonders effektiv in einen Plotter, in einen Matrixdrucker oder in einen Stift eingebaut werden. In einem Verfahren zum Erzeugen einer Struktur auf einem zu bearbeitenden Körper wird der zu bearbeitende Körper durch eine Energiequelle mit mindestens einer Elektrode, die zum Abgeben einer Energie vorgesehen ist, wenigstens teilweise erwärmt.

In dem Verfahren gemäß der Erfindung lassen sich die zuvor genannten Vorrichtungsmerkmale wirkungsgleich anwenden.

Die Erfindung wird im Folgenden anhand zweier nicht einschränkender Ausführungsbeispiele näher beschrieben. In den Zeichnungen zeigen:
Fig. 1 eine Vorrichtung mit einem erfindungsgemäß verwendeten Gerät gemäß einem ersten Ausführungsbeispiel;
Fig. 2 eine Vorrichtung mit einem erfindungsgemäß verwendeten Gerät gemäß einem zweiten Ausführungsbeispiel;
Fig. 3 das erfindungsgemäß verwendete Gerät gemäß dem zweiten Ausführungsbeispiel; und
Fig. 4 das erfindungsgemäß verwendete Gerät gemäß dem ersten Ausführungsbeispiel.

In den Figuren werden folgende Bezugszeichen verwendet:
- 10: Gerät
- 12, 14: Stifte
- 16, 18: Kontakt Stift
- 20, 22: Kontakt Stecker
- 24: Stecker
- 26: Polymerkörper
- 28: Leiterbahn
- 30: Umgebungsbereich
- 32: Gezeichnete Linien
- 34: Kontaktstelle
- 36: Unterseite
- 38: Gerät
- 40: Stift
- 42: Heizspirale
- 44: Schutzkörper
- 46: Stecker

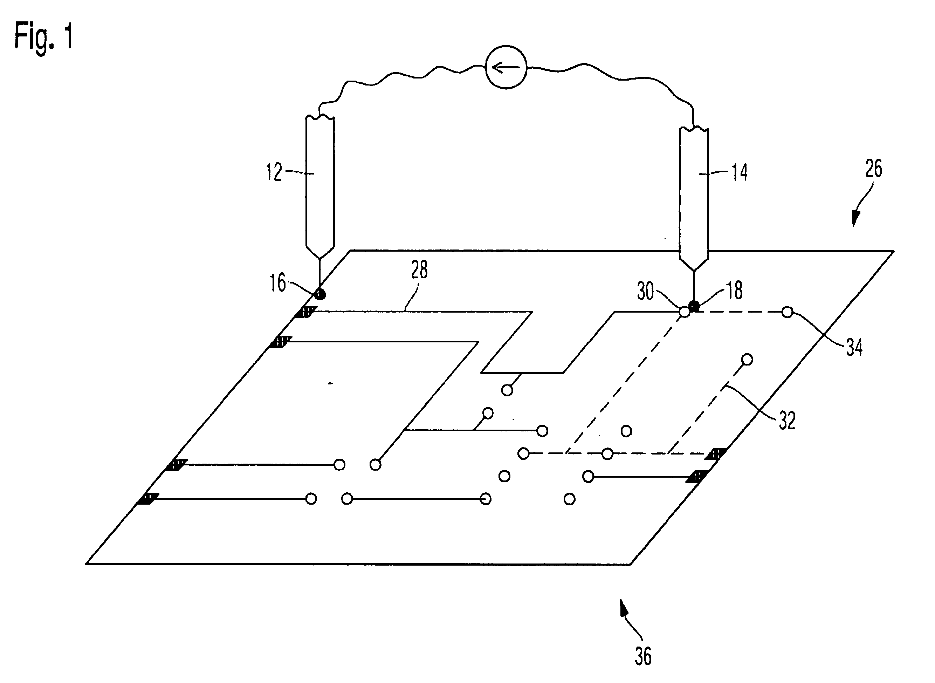

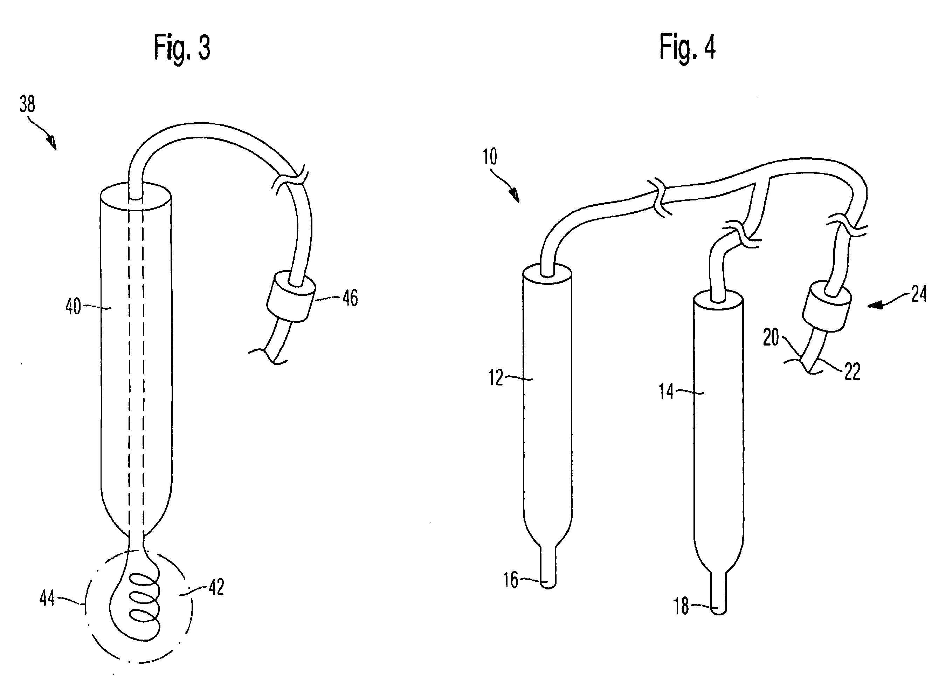

In einem ersten Ausführungsbeispiel, das in den Figuren 1 und 4 gezeigt ist, weist das Gerät 10 einen ersten Stift 12 und einen zweiten Stift 14 auf. Beide Stifte weisen jeweils an ihrer Unterseite einen Kontakt 16, 18 auf, die jeweils mit einem Kontakt 20, 22 eines Steckers 24 elektrisch verbunden sind.

Beim Anlegen der Kontakte 16, 18 der Stifte 12, 14 an einen Polymerkörper 26 aus mindestens einer Polymerphase mit Carbon-nanotubes lässt sich, wenn die Kontakte 16, 18 der Stifte 12, 14 voneinander beabstandet sind und einen Strom durch den Polymerkörper 26 leiten, der Polymerkörper 26 gezielt erwärmen. Durch die gezielte Erwärmung des Polymerkörpers 26 lassen sich auf diesem Leiterbahnen 28 aufbringen, die den Strom aus den Kontakten 16, 18 der Stifte 12, 14 ebenfalls führen können. Wird beispielsweise der erste Stift 12 mit dem ersten Kontakt 20 an einer Position fest fixiert und nur der zweite Stift 14 mit dem zweiten Kontakt 18 auf der Leiterplatte bewegt, so ist der Abstand zwischen der bereits erzeugten Leiterbahn und der aktuellen Position des zweiten Kontaktes 18 abhängig von der Bewegungsgeschwindigkeit sehr gering. Aus diesem geringen Abstand folgt ein geringer Widerstand zwischen der Leiterbahn 28 und dem zweiten Kontakt 18, wodurch die Leiterbahn 26 in einem Umgebungsbereich 30 um den zweiten Kontakt 18 des zweiten Stiftes 14 erwärmt wird, und sich so die Leiterbahn 28 fortsetzt.

Auf praktische Weise können nach einer möglichen Ausführungsform die zu erzeugenden Leiterbahnen auf dem Polymerkörper 26 mit vorgezeichneten Linien 32 angedeutet werden, um den Herstellungsprozess der Leiterplatte zu unterstützen. Weiter können am Polymerkörper 26 Kontaktstellen 34 hergestellt werden, die den Polymerkörper 26 durchdringen. Dazu muss lediglich der zweite Stift 12 von dem Polymerkörper 26 entfernt werden, und an der Unterseite 36 des Polymerkörpers 26 in etwa unter der bereits erzeugten Leiterbahn 28 angebracht werden. Dadurch wird wieder über die Leiterbahn 28 ein Strom zwischen den beiden Kontakten 16, 18 der beiden Stifte 12, 14 geleitet, der die Kontaktstelle 34 durch den Polymerkörper 26 erzeugt.

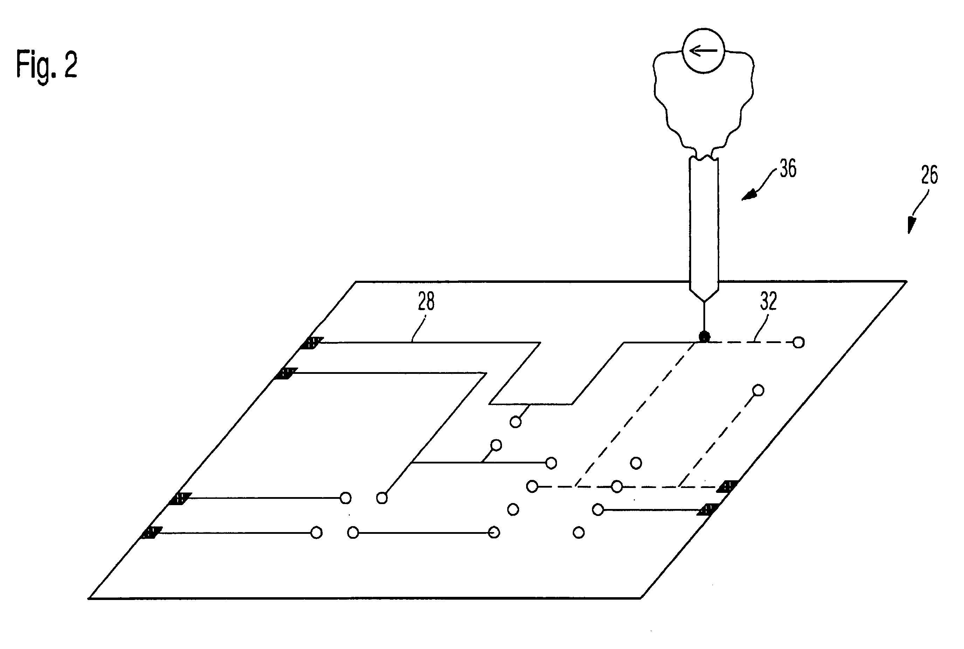

In den Figuren 2 und 3 ist ein erfindungsgemäß verwendetes Gerät gemäß einem zweiten Ausführungsbeispiel gezeigt. Danach umfasst das Gerät 38 einen Stift 40, an dessen Unterseite sich eine Heizspirale 42 anschließt. Diese Heizspirale ist vorzugsweise von einem Schutzkörper 44 umgeben. Der Schutzkörper kann dazu vorgesehen sein, die Erwärmung zu regulieren, oder aber auch um die Heizspirale 42 vor Verschmutzung oder anderen äußeren Einflüssen zu schützen. Weiter weist das Gerät 38 gemäß dem zweiten Ausführungsbeispiel einen Stecker 46 auf, mit dem die Heizspirale 42 mit elektrischer Energie versorgbar ist.

Im Einsatz wird das Gerät 38, wie im ersten Ausführungsbeispiel gezeigt, über die vorgezeichneten Linien 32 gezogen, so dass die bereits diskutierten Leiterbahnen 28 entstehen. In der vorliegenden Ausführungsform ist es nicht notwendig, einen ersten Stift an einer vorbestimmten Stelle des Polymerkörpers 26 zu positionieren.

Mit der Erfindung lassen sich auf einfache Weise Strukturen auf einem Körper erzeugen, ohne dass es dem Auftragen eines Grundmaterials und dem Entfernen der nicht benötigten Stellen des Grundmaterials bedarf. Dadurch werden Prozessschritte bei der Herstellung gespart, so dass die Produktion des zu bearbeitenden Körpers wirtschaftlicher wird. Demnach betrifft ein weiterer Aspekt der vorliegenden Erfindung die Verwendung der vorstehend beschriebenen Geräte, Vorrichtungen und Verfahren zur Erzeugung von (leitfähigen) Strukturen auf Polymerformkörpern gemäß der nachstehenden Patentansprüche.

Die vorstehenden Geräte, Vorrichtungen und Verfahren bieten besondere Vorteile bei der Verwendung der erfindungsgemäßen Polymerformkörper mit leitfähigen Strukturen auf der Oberfläche, wobei auch Verfahren zu dessen Herstellung beschrieben werden.

Für technische Anwendungen müssen elektronische Bauteile oder Bauelemente auf den leitfähigen Strukturen der erfindungsgemäßen Polymerformkörper aufgebracht werden. Hierzu ist es einerseits notwendig, dass eine ausreichende Stabilität der Bauteile oder Bauelemente auf den Leiterplatten gewährleistet und andererseits eine elektrisch leitfähige Verbindung zwischen den Leiterbahnen und den elektronischen Bauteilen oder Bauelementen hergestellt wird.

Im Rahmen der vorliegenden Erfindung wurde überraschend festgestellt, dass besonders vorteilhafte Leiterplatten-Anordnungen hergestellt werden können, wenn Polymerformkörper mit CNTs als Leiterplatten verwendet werden und auf die durch thermische Behandlung erzeugten leitfähigen Strukturen bzw. Leiterbahnen unter Verwendung einer erfindungsgemäßen organischen Klebstoff-Zusammensetzung, die ebenfalls CNTs enthält, elektronische Bauelemente aufgebracht werden. Überraschenderweise ermöglicht die Verwendung eines CNT-haltigen Klebstoffes auf einer CNT-haltigen Leiterplatte eine besonders gute Fixierung der elektronischen Bauteile oder Bauelemente. Hingegen führt die Verwendung von Klebstoffen mit leitfähigen Stoffen wie beispielweise Silberpartikeln zu einer schlechten Adhäsion auf CNT-haltigen Substraten.

Hierbei hat sich gezeigt, dass besonders gute elektrische Eigenschaften durch die kombinierte Verwendung eines CNT-haltigen Klebstoffs und einer CNT-haltigen Leiterplatte erzielt werden.

Überraschenderweise können Bauelemente zudem in sehr zuverlässiger und belastbarer Weise mit geringem Arbeitszeitaufwand durch Herstellung einer Bindung, die CNT umfassendes Material enthält, und/oder durch eine Lötverbindung auf einer Leiterplatte, die einen CNT-haltigen Polymerformkörper umfasst, angebracht werden, wie nachstehend detailliert erläutert. Der Begriff "Bindung" umfasst dabei jegliche Anheftung oder Anbindung unter Verwendung von CNT enthaltendem Material, insbesondere einem CNT-haltigen Polymermaterial. Besonders bevorzugt handelt es sich bei dem CNT umfassenden Material um das Material des hierin beschriebenen Polymerformkörpers.

Eine bevorzugte Leiterplatten-Anordnung umfasst daher mindestens eine Leiterplatte mit mindestens einer elektrisch leitfähigen Leiterbahn und mindestens einem elektronischen Bauelement, wobei die Leiterplatte einen Polymerformkörper mit 0,1-10 Gew.-%, weiter bevorzugt 1-10 Gew.-%, und noch weiter bevorzugt 5-10 Gew.-%, Carbon Nanotubes (CNT), bezogen auf die Masse der Polymerphase/n, umfasst, und wobei weiter bevorzugt das mindestens eine elektronische Bauelement durch eine organische Klebstoff-Zusammensetzung enthaltend 0,05-10 Gew.%, weiter bevorzugt 0,1-10 Gew.-%, weiter bevorzugt 1-10 Gew.-%, und am meisten bevorzugt 5-10 Gew.-%, Carbon-Nanotubes (CNT), bezogen auf die Masse der Klebstoff-Zusammensetzung, und/oder durch eine Bindung, die Carbon Nanotubes (CNT) enthaltendes Material, insbesondere eine oder mehrere Carbon Nanotubes (CNT) enthaltende Polymerphasen, umfasst, und/oder durch eine Lötverbindung mit mindestens einer elektrisch leitfähigen Leiterbahn der Leiterplatte verbunden ist. Die elektrisch leitfähigen Leiterbahnen werden hierbei durch Bereiche der Oberfläche des Polymerformkörpers gebildet, die eine erhöhte CNT-Konzentration aufweisen.

Für die Leiterplatten-Anordnung können alle erfindungsgemäßen Klebstoff-Zusammensetzungen, die hier beschrieben sind, verwendet werden. Besonders bevorzugt wird ein Urethanacrylat-Klebstoff verwendet. Weiter bevorzugt weist die Verbindung zwischen der mindestens einen elektrisch leitfähigen Leiterbahn und dem mindestens einen elektronischen Bauelement einen elektrischen Widerstand von weniger als 50 Ohm auf.

Des Weiteren betrifft die Erfindung die Verwendung einer Klebstoff-Zusammensetzung gemäß Anspruch 15, vorzugsweise enthaltend 0,05-10 Gew.% Carbon-Nanotubes (CNT). Die Klebstoff-Zusammensetzung kann durch Vermischen der CNTs mit den KlebstoffKomponenten erfolgen. Hierzu geeignete Verfahren sind dem Fachmann bekannt.

Bevorzugterweise kommen hierbei solche Klebstoffe zum Einsatz, welche eine Substanz enthalten, die unter Einfluss von Strahlung oder Wärme reagieren oder eine Substanz freisetzen, die mit den reaktiven Bestandteilen des Klebstoffs reagieren oder deren Polymerisation auslösen oder katalysieren. Bevorzugt enthält die Klebstoff-Zusammensetzung Acrylat-Klebstoffe, Phenol-Formaldehydharz-Klebstoffe, Silicon-Klebstoffe, oder Polyurethan-Klebstoffe, bevorzugt Acrylat-Klebstoffe. Weiter bevorzugt ist die Klebstoffzusammensetzung ausgewählt aus der Gruppe bestehend aus Cyanacrylat-Klebstoffen, Methylmethacrylat-Klebstoffen, Urethanacrylat-Klebstoff, Butylacrylat, und strahlenhärtbaren AcrylatKlebstoffen, insbesondere wird ein Urethanacrylat-Klebstoff verwendet. Besonders bevorzugt besteht die erfindungsgemäße Klebstoffzusammensetzung nur aus CNTs und den vorgenannten Klebstoffen oder Gemischen davon.

Bevorzugterweise beträgt der elektrische Widerstand der Klebstoff-Zusammensetzung weniger als 100, insbesondere weniger als 50 Ohm.

Die vorliegende Erfindung betrifft zudem die Verwendung einer erfindungsgemäßen Klebstoff-Zusammensetzung gemäß Anspruch 15 zum elektrisch leitfähigen Verbinden eines elektronischen Bauelements mit einem anderen elektrisch leitfähigen Bauteil oder Formteil, insbesondere einer elektrisch leitfähigen Leiterbahn oder einem elektrisch leitfähigen Bereich auf einer Leiterbahn.

Des Weiteren offenbart wird ein Verfahren zum Aufbringen mindestens eines elektronischen Bauelements auf eine Leiterplatte umfassend die folgenden Schritte:
a) Bereitstellen einer Leiterplatte mit mindestens einer elektrisch leitfähigen Leiterbahn oder mindestens einem elektrisch leitfähigen Bereich, wobei die Leiterplatte einen Polymerformkörper mit 0,1-10 Gew.-% Carbon Nanotubes (CNTs), bezogen auf die Masse der Polymerphase/n, darstellt,
b) Bereitstellen mindestens eines elektronischen Bauelements, und
c) Verbinden, vorzugsweise thermisch und/oder elektrisch leitfähiges Verbinden, des elektronischen Bauelements mit der elektrisch leitfähigen Leiterbahn oder dem mindestens einen elektrisch leitfähigen Bereich unter Verwendung der erfindungsgemäßen Klebstoff-Zusammensetzung und/oder durch Herstellen einer Bindung, die Carbon Nanotubes (CNT) enthaltendes Material, insbesondere eine oder mehrere Carbon Nanotubes (CNT) enthaltende Polymerphasen, umfasst, und/oder durch Herstellen einer Lötverbindung.

Bevorzugterweise wird in Schritt a) des Verfahrens der Polymerformkörper mit elektrisch leitfähigen Strukturen mit dem erfindungsgemäßen Verfahren, wie im Vorangegangenen beschrieben, hergestellt. Bevorzugterweise wird hierbei mit dem erfindungsgemäßen Gerät eine leitfähige Struktur erzeugt.

Geeignete elektronische Bauteile oder Bauelemente, die auf Leiterplatten aufgebracht werden können, sind dem Fachmann bekannt. Diese Bauteile oder Bauelemente können üblicherweise "metallische Beinchen" aufweisen, die in Kontakt mit der Leiterplatte bzw. den hierauf befindlichen leitfähigen Strukturen gebracht werden müssen oder können. Beispiele für elektronische Bauteile oder Bauelemente sind insbesondere oberflächenmontierbare Bauteile (surface-mounted devices, SMDs). Oberflächenmontierbare Bauteile (SMDs) können insbesondere über ihre Anschlüsse, insbesondere ihre Anschlussflächen, auf einer Leiterplatte angebracht werden. Die Anbringung kann über dem Fachmann bekannte Verfahren der Oberflächenmontagetechnik (surface-mounting technology) erfolgen. Vorgehensweisen zur Anbringung von Bauelementen, insbesondere SMDs, die hervorragende Ergebnisse in Kombination mit Leiterplatten, die einen CNT umfassenden Polymerformkörper aufweisen, ergeben, sind nach- und vorstehend erläutert. Bei den SMDs kann es sich beispielsweise um Widerstände, Spulen, Kondensatoren, insbesondere Keramik-Kondensatoren, Tantal-Elkos, Aluminium-Elkos, Quarze, Dioden, Transistoren, Spannungsregler, Leuchtdioden, Potentiometer, Trimmer, Taster, Optokoppler, Reedkontakte oder Integrierte Schaltungen handeln.

Insbesondere können die elektronischen Bauteile oder Bauelemente Anschlüsse an mindestens einer, insbesondere einer, zwei, drei oder vier Flächen, insbesondere Seitenflächen des Gehäuses aufweisen. Der Begriff "Beinchen eines Bauelements", sowie die Begriffe "Abschnitt des elektronischen Bauelements", insbesondere "Abschnitt des elektronischen Bauelements, der mit dem zumindest teilweise geschmolzenen Abschnitt des Polymerformkörpers oder der elektrisch leitfähigen Bahn oder des elektrisch leitfähigen Bereichs in Kontakt kommt oder in Kontakt gebracht wird", wie im Rahmen der vorliegenden Anmeldung verwendet, umfasst insbesondere Anschlüsse von oberflächenmontierbaren Bauteilen (SMDs), die beispielsweise in Form von Stäbchen oder Plättchen oder in Form von Anschlussflächen vorliegen können. Die Anschlüsse können dabei vorzugsweise eine oder mehrere Biegungen umfassen, und beispielsweise in "Gull-Wing"- oder "J-Lead"-Form vorliegen.

Elektronische Bauteile oder Bauelemente, die auf Leiterplatten aufgebracht werden können, können SMD-Bauformen oder SMD-Gehäuse aufweisen.

Im Rahmen der vorliegenden Erfindung können eine oder mehrere Bauelemente, die insbesondere eine Bauform oder ein Gehäuse aufweisen können, die/das ausgewählt ist unter MELF (Metal Electrode Faces), Chip-Bauform, V-Chip-Bauform, SOD (Small Outline Diode), SOT (Small Outline Transitor), DIL (Dual-In-Line), SOIC (Small-Outline Integrated Circuit), SOP (Small Outline Package), PLCC (plastic leaded chip carrier), QFP (Quad Flat Package), MLP (Micro Leadframe Package), MLF (Micro Lead Frame), QFN (Quad Flat pack No leads), LGA (Land Grid Array), BGA (Ball Grid Array) und deren Kombinationen, auf einer Leiterplatte, insbesondere einer einen Carbon Nanotubes umfassenden Polymerformkörper aufweisenden Leiterplatte, angebracht werden.

Die Anbringung der Bauelemente, insbesondere der SMDs, kann im Rahmen der vorliegenden Erfindung, beispielsweise unter Verwendung von Klebstoffen, insbesondere Carbon Nanotubes umfassenden Klebstoffzusammensetzungen, die vorzugsweise 0,05 bis 10 Gew.-% Carbon-Nanotubes umfassen, und/oder unter Verwendung von Lötverbindungen und/oder durch eine Bindung, die Carbon Nanotubes enthaltendes Material umfasst, erfolgen.

Die Lötverbindung kann insbesondere unter Verwendung eines Lots, insbesondere einer Lötpaste hergestellt werden, das z.B. Zinn und/oder Blei umfassen kann. Als Lötverfahren kann ein dem Fachmann bekanntes Lötverfahren angewendet werden. Eine sehr gute Befestigung kann bei der Anbringung des Bauelements durch Anwendung des Reflow-Lötverfahrens erhalten werden. Hierbei kann zunächst ein Lot in Form einer Lötpaste auf die Leiterplatte aufgetragen werden, anschließend kann das Bauelement auf eine mit Lötpaste versehene Stelle der Leiterplatte aufgebracht werden und weiter anschließend die Lötpaste mindestens auf eine Temperatur erhitzt werden, bei der es zu einem Schmelzen der Lötpaste kommt.

Klebstoffe und/oder Lötpaste (zur Herstellung einer Lötverbindung, insbesondere beim Reflow-Löten) können gemäß dem allgemeinen Fachwissen aufgebracht werden. Sehr gute Ergebnisse können insbesondere verwendet werden, wenn Lötpaste oder Klebstoff mittels Siebdruck aufgebracht wird oder in kleinen Portionen, insbesondere unter Verwendung von Dosiervorrichtungen, aufgebracht wird.

Da die erfindungsgemäß verwendete Klebstoffzusammensetzung leitfähig ist, kann sich auch Klebstoff zwischen den Beinchen und der leitfähigen Struktur befinden. Um die Bauteile oder Bauelemente auf die Leiterplatte aufzubringen, können die Beinchen der Bauteile oder Bauelemente beispielsweise in die Klebstoff-Zusammensetzung eingetaucht werden und anschließend auf die Leiterplatte aufgesetzt werden. Dabei muss die Menge an Klebstoff so gewählt werden, dass eine ausreichende Stabilität zwischen dem Bauteil oder Bauelement und der Leiterplatte erzeugt wird, jedoch keine benachbarten Leiterbahnen mit Klebstoff in Kontakt kommen. Das Aushärten der Klebstoff-Zusammensetzung kann dann auf übliche Weise, beispielsweise unter Verwendung einer UV-Lampe, erfolgen.

Das Verbinden, vorzugsweise das thermisch und/oder elektrisch leitfähige Verbinden, des elektronischen Bauelements mit dem Polymerformkörper oder der mindestens einen elektrisch leitfähigen Leiterbahn oder dem mindestens einen elektrisch leitfähigen Bereich kann weiterhin durch Herstellen einer Bindung, die Carbon Nanotubes (CNT) enthaltendes Material, insbesondere eine oder mehrere Carbon Nanotubes (CNT) enthaltende Polymerphasen, umfasst, erfolgen. Besonders vorteilhaft ist nach dieser Ausführungsform der Erfindung die Anbringung des Bauteils in einem Arbeitsschritt, ggf. im gleichen Arbeitsschritt wie die Erzeuging der Leiterbahnen auf dem Polymerformkörper, die dauerhafte Verbindung und die Vermeidung von Lot.

Zudem kann das Verbinden des elektronischen Bauelements mit dem Polymerformkörper oder der mindestens einen elektrisch leitfähigen Leiterbahn oder dem mindestens einen elektrisch leitfähigen Bereich auch durch Herstellen einer Bindung, die Carbon Nanotubes (CNT) enthaltendes Material umfasst, in Kombination mit einer Verwendung einer erfindungsgemäßen Klebstoff-Zusammensetzung und/oder einer Lötverbindung, erfolgen.

Insbesondere kann mindestens ein erster Abschnitt des Bauelements unter Verwendung der erfindungsgemäßen Klebstoff-Zusammensetzung und zudem mindestens ein zweiter Abschnitt des Bauelements unter Herstellung einer Bindung, die Carbon Nanotubes (CNT) enthaltendes Material umfasst, angebracht werden. Die jeweils geeignete Weise des Verbindens kann ein Fachmann auf Basis seines allgemeinen Fachwissens, sowie auf Basis der jeweils herzustellenden Leiterplattenanordnung und den anzubringenden elektronischen Bauelementen auswählen.

Der Begriff "Carbon Nanotubes (CNT) enthaltendes Material" umfasst im Rahmen der vorliegenden Anmeldung insbesondere ein- oder mehrphasige Zusammensetzungen, die Carbon Nanotubes umfassen, insbesondere Zusammensetzungen, die ein oder mehrere Polymere, sowie Carbon Nanotubes, insbesondere mindestens zwei oder mehr phasenunverträgliche Polymere, sowie Carbon Nanotubes, umfassen.

Zum Herstellen einer Bindung, die Carbon Nanotubes (CNT) enthaltendes Material umfasst, kann zunächst ein Zuführen von Energie zu mindestens einem Abschnitt, insbesondere einem Oberflächenabschnitt, des CNT enthaltenden Polymerformkörpers oder der elektrisch leitfähigen, insbesondere CNT enthaltenden Bahn oder des elektrisch leitfähigen, insbesondere CNT enthaltenden Bereichs erfolgen, wobei der Abschnitt des Polymerformkörpers, der elektrisch leitfähigen Bahn oder des elektrisch leitfähigen Bereichs, dem die Energie zugeführt wurde, zumindest teilweise schmilzt.

Das Zuführen von Energie kann insbesondere durch Kontakt mit einem erhitzten Körper, Gas (z.B. Heißluft) oder Flüssigkeit, oder durch elektromagnetische Strahlung erfolgen. Ein Fachmann kann das jeweils geeignete Mittel auswählen, um Energie zuzuführen bzw. einen definierten Bereich der Oberfläche anzuschmelzen.

Der Begriff "zumindest teilweise schmilzt" umfasst im Rahmen der vorliegenden Anmeldung neben einem teilweisen oder vollständigen Schmelzen, auch jegliches Anschmelzen, insbesondere jegliches partielle Anschmelzen, sowie jegliche Veränderung des Polymerformkörpers, der elektrisch leitfähigen Bahn oder des elektrisch leitfähigen Bereichs, die ein Einsinken des Abschnitts (oder eines Teilbereichs hiervon) des anzubringenden Bauelements in das Material des Polymerformkörpers oder der leitfähigen Bahn oder des elektrisch leitfähigen Bereichs oder ein Benetzen hiermit ermöglicht. Insbesondere kann der Abschnitt des Polymerformkörpers, der leitfähigen Bahn oder des leitfähigen Bereichs auf eine Temperatur erhitzt werden, die mindestens der Schmelztemperatur des Materials bzw. mindestens der niedrigsten Schmelztemperatur der jeweiligen Materialien des Polymerformkörpers oder der leitfähigen Bahn oder des elektrisch leitfähigen Bereichs entspricht.

Der Schritt des Zuführens von Energie zu mindestens einem Abschnitt, insbesondere einem Oberflächenabschnitt, des CNT enthaltenden Polymerformkörpers, der elektrisch leitfähigen Bahn oder des elektrisch leitfähigen Bereichs, kann insbesondere dadurch erfolgen, dass ein Erwärmen eines Abschnitts des elektronischen Bauelements, der mit dem Polymerformkörper, der elektrisch leitfähigen Bahn oder dem elektrisch leitfähigen Bereich in Kontakt steht oder für ein in Kontakt kommen mit einem Abschnitt des Polymerformkörpers, der elektrisch leitfähigen Bahn oder des elektrisch leitfähigen Bereichs ausgelegt ist und nach dem Erwärmen mit diesem in Kontakt gebracht wird, erfolgt und/oder dass ein Erwärmen mindestens eines Abschnitts des Polymerformkörpers, der elektrisch leitfähigen Bahn oder des elektrisch leitfähigen Bereichs erfolgt. Der Begriff "Abschnitt eines elektronischen Bauelements", insbesondere "Abschnitt des elektronischen Bauelements, der mit dem zumindest teilweise geschmolzenen Abschnitt des Polymerformkörpers oder der elektrisch leitfähigen Bahn oder des elektrisch leitfähigen Bereichs in Kontakt kommt oder in Kontakt gebracht wird", kann im Rahmen der vorliegenden Erfindung beliebige für eine Anbringung auf einer Leiterplatte durch einen Fachmann ausgewählte Abschnitte eines elektronischen Bauelements umfassen. Insbesondere umfassen diese Begriffe einen oder mehrere Anschlüsse beliebiger Form eines oberflächenmontierbaren Bauteils (SMD), insbesondere in Form einer Anschlussfläche, vorzugsweise in Form eines "Beinchens" oder einen oder mehrere Anschlüsse eines anderen Bauelements, die insbesondere die Form eines "Beinchens" aufweisen können. Derartige Abschnitte von Bauelementen, insbesondere Anschlüsse von SMDs, können ein oder mehrere Metalle, insbesondere metallische Legierungen, umfassen oder hieraus bestehen.

Das Erwärmen des Abschnitts des elektronischen Bauelements und/oder des mindestens einen Abschnitts des Polymerformkörpers, der elektrisch leitfähigen Bahn oder des elektrisch leitfähigen Bereichs kann dabei in direkter Weise erfolgen, in dem mit einer Energiequelle, z.B. elektromagnetischer Strahlung, insbesondere Laserstrahlung oder IR-Strahlung, auf den jeweiligen Abschnitt des elektronischen Bauelements und/oder des mindestens einen Abschnitt des Polymerformkörpers, der elektrisch leitfähigen Bahn oder des elektrisch leitfähigen Bereichs eingewirkt wird, oder kann in indirekter Weise erfolgen, in dem auf eine Einrichtung oder einen weiteren Abschnitt des Bauelements eingewirkt wird, die oder der in thermisch und/oder elektrisch leitfähiger Weise mit dem zu erwärmenden Abschnitt des elektronischen Bauelements verbunden ist.

In einem nächsten Schritt kann ein in Kontakt Kommen oder in Kontakt Bringen eines Abschnitts des elektronischen Bauelements, beispielsweise eines Beinchens des Bauelements, mit dem zumindest teilweise geschmolzenen Abschnitt des Polymerformkörpers, der elektrisch leitfähigen Bahn oder des elektrisch leitfähigen Bereichs erfolgen.

Bei einem in Kontakt kommen kann sich insbesondere der Abschnitt des anzubringenden Bauelements bereits auf der Leiterplatte, insbesondere dem Polymerformkörper, vorzugsweise der elektrisch leitfähigen Bahn oder dem elektrisch leitfähigen Bereich befinden und dort mit der Schmelze in Kontakt kommen. Beispielsweise kann der Abschnitt des anzubringenden Bauelements erhitzt werden, was dazu führt, dass an diesen Bauelement-Abschnitt angrenzendes CNT umfassendes Material, insbesondere des Polymerformkörpers, der elektrisch leitfähigen Bahn oder des elektrisch leitfähigen Bereichs, durch den Kontakt mit dem erhitzten Abschnitt schmilzt, und/oder es kann an den Abschnitt des Bauelements angrenzendes CNT umfassendes Material, insbesondere des Polymerformkörpers, der elektrisch leitfähigen Bahn oder des elektrisch leitfähigen Bereichs, zum Schmelzen gebracht werden, wobei dies dazu führt, dass CNT umfassende Schmelze dann mit dem Abschnitt des anzubringenden Bauelements in Kontakt kommt.

Insbesondere kann auch ein CNT umfassender Abschnitt des Polymerformkörpers, der benachbart zu einer elektrisch leitfähigen Bahn oder einem elektrisch leitfähigen Bereich ist, derart angeschmolzen werden, dass nach dem Ausbilden der Bindung ein elektrisch leitfähiger Kontakt zwischen der Bindung bzw. dem Bauelement und der elektrisch leitfähigen Bahn oder dem elektrisch leitfähigen Bereich vorliegt. Gegebenenfalls kann nach der Ausbildung der Bindung gemäß den vorstehend erwähnten Verfahren eine zusätzliche elektrisch leitfähige Bahn erstellt werden, welche die Bindung mit der elektrisch leitfähigen Bahn oder dem elektrisch leitfähigen Bereich, insbesondere in elektrisch oder thermisch leitfähiger Weise verbindet.

In einem nächsten Schritt erfolgt dann ein Ausbilden oder Ausbilden lassen einer Bindung, insbesondere einer elektrisch leitfähigen Bindung, zwischen dem Abschnitt des elektronischen Bauelements und dem mindestens einen Abschnitt des Polymerformkörpers, der elektrisch leitfähigen Bahn oder des elektrisch leitfähigen Bereichs. Sehr vorteilhaft ist, dass die Bildung der Bindung auch ohne weitere Maßnahmen oder Schritte einfach beim Erkalten lassen der Schmelze, die mit einem Abschnitt des Bauelements in Kontakt steht, erfolgen kann. Optional kann ein Fachmann weitere Maßnahmen ergreifen, die den Kontakt zwischen der Schmelze und dem Abschnitt des Bauelements weiter verbessern.

Beispielsweise kann gemäß einer Ausführungsform das Bauelement auf die Leiterplatte, vorzugsweise auf den Polymerformkörper, aufgebracht werden, wobei der anzubringende Abschnitt des Bauelements vorzugsweise vollständig oder zumindest teilweise mit der elektrisch leitfähigen Bahn oder dem elektrisch leitfähigen Bereich in Kontakt steht. Anschließend kann dann mit einer Licht- oder Wärmequelle (wie z.B. einem Laser) auf einen Abschnitt des Bauelements, beispielsweise auf ein Beinchen des Bauelements, das in thermisch leitender Verbindung mit einem hieran angrenzenden Bereich des Polymerformkörpers, insbesondere der elektrisch leitfähigen Bahn oder des elektrisch leitfähigen Bereichs, steht, eingewirkt werden, so dass dieser aufschmilzt und die Schmelze mit dem Beinchen in Kontakt kommt.

Zusätzlich oder alternativ zu einem Einwirken auf einen Abschnitt des Bauelements kann mit einer Licht- oder Wärmequelle (wie z.B. einem Laser) auf einen an den Abschnitt des Bauelements, beispielsweise an ein Beinchen des Bauelements, angrenzenden Bereich des Polymerformkörpers, insbesondere der elektrisch leitfähigen Bahn oder des elektrisch leitfähigen Bereichs, eingewirkt werden, so dass dieser aufschmilzt und die Schmelze mit dem Beinchen in Kontakt kommt.

Beim Abkühlen und bei dem dabei erfolgenden Verfestigen der Schmelze, kommt es dann zu einer Ausbildung einer Bindung zwischen dem Abschnitt des Bauelements, beispielsweise eines Beinchens, und der Leiterplatte, insbesondere dem Polymerformkörper, vorzugsweise der elektrisch leitfähigen Bahn oder des elektrisch leitfähigen Bereichs. Auf diese Weise kann in sehr vorteilhafter Weise und mit geringem Arbeitsaufwand gleichzeitig ein Bauelement befestigt und eine sehr gut elektrisch leitfähige Verbindung bereitgestellt werden.

Gemäß einer weiteren Ausführungsform kann mit einer Licht- oder Wärmequelle (z.B. einem Laser) auf den Polymerformkörper, insbesondere eine elektrisch leitfähige Bahn oder einen elektrisch leitfähigen Bereich hiervon, eingewirkt werden, wobei es an der Stelle der Licht- oder Wärmeeinwirkung zu einem lokal begrenzten Schmelzen, insbesondere eines Oberflächenabschnitts hiervon, kommt. Anschließend werden ein oder mehrere Abschnitte des anzubringenden Bauelements, beispielsweise ein oder mehrere Beinchen des Bauelements, dann mit dieser Schmelze umfassenden Stelle in Kontakt gebracht. Beim Abkühlen und bei dem dabei erfolgenden Verfestigen der Schmelze, kommt es zu einer Ausbildung einer Bindung zwischen dem Abschnitt des Bauelements, beispielsweise eines Beinchens, und der Leiterplatte, insbesondere dem Polymerformkörper, vorzugsweise der elektrisch leitfähigen Bahn oder dem elektrisch leitfähigen Bereich. Auf diese Weise kann in sehr vorteilhafter Weise und mit geringem Arbeitsaufwand ein Bauelement gleichzeitig befestigt und eine sehr gut elektrisch leitfähige Bindung bereitgestellt werden.

Wenn erwünscht, können gemäß einer weiteren Ausführungsform sowohl ein Abschnitt des Bauelements, beispielsweise ein Beinchen hiervon, als auch ein Abschnitt der Leiterplatte, insbesondere des Polymerformkörpers, insbesondere einer elektrisch leitfähigen Bahn oder eines elektrisch leitfähigen Bereichs hiervon, erwärmt werden.

Das Erwärmen kann insbesondere auf eine Temperatur oberhalb des Schmelzpunkts des Materials des Abschnitts an den das Bauelement unter Ausbildung einer Bindung angebracht werden soll, erfolgen. Je länger und mit je größerer Energiemenge die Oberfläche des Polymerformkörpers angeschmolzen wird, um so tiefer erstreckt sich der angeschmolzene Bereich, wie vorstehend detailliert erläutert, in die Oberfläche hinein und desto mehr Carbon Nanotubes migrieren an die Oberfläche, wobei hierdurch die elektrische Leitfähigkeit der Struktur erhöht wird. Durch die Wahl der Dauer des Erhitzens und der Menge der zugeführten Energie kann auf diese Weise die Leitfähigkeit der Bindung zwischen dem Abschnitt des Bauelements und dem Polymerformkörper, insbesondere einer elektrisch leitfähigen Bahn oder eines elektrisch leitfähigen Bereichs hiervon, beeinflußt werden.

Sehr gute Ergebnisse und eine hohe Verlässlichkeit der Anbringung können insbesondere erhalten werden, wenn der vorstehend erläuterte Schritt des Zuführens von Energie beziehungsweise des Erwärmens unter Verwendung eines Lasers erfolgt.

Geeignete Laser für das Verfahren des Aufbringens des elektronischen Bauelements sind: HeNe-Laser, Nd:YAG-Laser, Kohlendioxidlaser (CO₂-Laser), Kohlenmonoxidlaser (CO-Laser), Stickstofflaser (N₂-Laser), Argon-Ionen-Laser, Helium-Cadmium-Laser (HeCd-Laser), Krypton-Ionen-Laser, Sauerstoff-Ionen-Laser, Xenon-Ionen-Laser, Mischgas-Laser (beispielsweise mit Argon und Krypton), Excimerlaser, Metalldampflaser (beispielsweise Kupferdampflaser) und Metallhalogenid-Laser (beispielsweise Kupferbromid-Laser), bevorzugt sind Kohlendioxidlaser (CO₂-Laser) und Nd:YAG-Laser.

Die Bindung kann eine oder mehrere Carbon Nanotubes (CNT) enthaltende Polymerphasen umfassen oder aus diesen bestehen, wobei dies, wenn erwünscht, von einem Fachmann durch die Wahl der Dauer des Erhitzens und der Menge an zugeführter Energie, sowie das Material des Polymerformkörpers, das vorstehend detailliert erläutert wurde, variiert werden kann.

Zudem kann das Herstellen der Bindung derart erfolgen, dass die Bindung mindestens eine Carbon Nanotubes (CNT) enthaltende Polymerphase umfasst oder aus dieser besteht, die einen Gehalt von 0,05-10 Gew.-% Carbon Nanotubes (CNT), vorzugsweise von 0,1-10 Gew.-% Carbon Nanotubes (CNT), bevorzugt von 0,2-10 Gew.-% Carbon Nanotubes (CNT), jeweils bezogen auf die Masse der Polymerphase, aufweist.

Der Begriff "Bauelement, verbunden mit der mindestens einen elektrisch leitfähigen Leiterbahn oder dem mindestens einen elektrisch leitfähigen Bereich durch eine Klebstoff-Zusammensetzung und/oder durch eine Bindung und/oder durch eine Lötverbindung", kann insbesondere umfassen, dass das Bauelement unmittelbar und/oder über eine oder mehrere Verbindungsvorrichtungen mit der Klebstoff-Zusammensetzung und/oder der Bindung und/oder der Lötverbindung in Kontakt steht, sowie dass die mindestens eine elektrisch leitfähige Leiterbahn oder der mindestens eine elektrisch leitfähige Bereich unmittelbar und/oder über eine oder mehrere Verbindungsvorrichtungen mit der der Klebstoff-Zusammensetzung und/oder der Bindung und/oder der Lötverbindung in Kontakt steht.

Weiterhin kann ein Bauteil oder (elektronisches) Bauelement insbesondere dadurch angebracht werden, dass zunächst eine elektrisch leitfähiges Material umfassende Verbindungsvorrichtung auf einer Leiterplatte, insbesondere auf einer Leiterplatte mit einem Carbon Nanotubes umfassenden Polymerformkörper derart angebracht wird, dass die Verbindungsvorrichtung mit einer oder mehreren elektrisch leitfähigen Leiterbahn(en) und/oder elektrisch leitfähigen Bereich(en) in elektrisch leitfähigem Kontakt steht. Anschließend wird auf dieser Verbindungsvorrichtung das Bauteil oder (elektronische) Bauelement, beispielsweise durch Verlöten oder Verkleben, derart aufgebracht, dass das Bauteil oder (elektronische) Bauelement in elektrisch leitfähiger Weise mit der einen oder den mehreren elektrisch leitfähigen Leiterbahn(en) und/oder elektrisch leitfähigen Bereich(en) verbunden ist.

Bei der leitfähiges Material umfassenden Verbindungsvorrichtung kann es sich um eine ein oder mehrere Metall(e) oder Legierungen umfassende oder hieraus bestehende Vorrichtung handeln. Insbesondere kann die leitfähiges Material umfassende Verbindungsvorrichtung eine Öse oder eine Schicht auf dem Polymerformkörper sein, auf der beispielsweise durch Verkleben oder Verlöten z.B. ein oberflächenmontierbares Bauteil (SMD) angebracht wird.

Gemäß einer Ausführungsform kann die Leiterplattenanordnung eine Lötverbindung, optional in Kombination mit einer CNT enthaltendes Material umfassenden Bindung und/oder einer durch eine CNT umfassende organische Klebstoffzusammensetzung hergestellten Verbindung umfassen. Durch die Lötverbindung kann eine elektrisch leitfähige Verbindung zwischen mindestens einem Abschnitt eines Bauelements, insbesondere mindestens einem Abschnitt eines SMDs, weiter insbesondere mindestens einem Anschluss eines SMD und dem Polymerformkörper, insbesondere den elektrisch leitfähigen Bahnen und Bereichen auf und/oder in dem Polymerformkörper, hergestellt werden. Insbesondere kann die Lötverbindung das Bauelement mit einer Schicht, die Metall, insbesondere Kupfer und/oder Zinn umfasst, die auf der Leiterplatte, insbesondere dem Polymerformkörper angeordnet ist und in elektrisch leitfähigem Kontakt mit einer elektrisch leitfähigen Leiterbahn oder einem elektrisch leitfähigen Bereich hiervon steht, in elektrisch leitfähiger Weise verbinden.

Ein weiterer Aspekt der Erfindung betrifft eine Leiterplatten-Anordnung, wobei die Leiterplatte einen erfindungsgemäßen Polymerformkörper umfasst, gemäß Anspruch 9. Der erfindungsgemäße Polymerformkörper kann, wie oben beschrieben, hergestellt und mit elektrisch leitfähigen Strukturen bzw. Leiterbahnen versehen werden. Bei dieser Leiterplatten-Anordnung kann die Anbringung von Bauelementen, insbesondere der vorstehend Genannten, gemäß einer der zuvor angegebenen Vorgehensweisen erfolgen. Um die elektrische Leitfähigkeit der Strukturen mit erhöhter CNT-Konzentration weiter zu erhöhen ist es nach einer möglichen Ausführungsform bevorzugt, eine Metallschicht, bevorzugterweise eine Kupferschicht, aufzubringen. Somit befindet sich eine Metallschicht auf der leitfähigen Struktur aus Polymer mit erhöhter CNT Konzentration (verglichen mit der CNT Konzentration in den nicht leitfähigen Bereichen). Wie oben beschrieben, wird in einer Ausführungsform der Erfindung die gesamte Oberfläche, oder eine von mehreren Oberflächen der CNT-enthaltenden Polymerphase erfindungsgemäß behandelt, sodass keine nicht leitfähigen Oberflächenbereiche verbleiben. Die entstehenden leitfähigen Oberflächen können ebenfalls mit einer Metallschicht versehen werden. Dies ermöglicht eine Vielzahl von elektronischen Anwendungen.

Überraschenderweise wurde im Rahmen der vorliegenden Erfindung festgestellt, dass die Polymerformkörper mit den elektrisch leitfähigen Strukturen direkt in einem Galvanisierverfahren verwendet werden können und eine Kupferschicht direkt gezielt auf die Polymerformkörper aufgebracht werden kann. Im Vergleich zu bisher verwendeten Galvanisierverfahren für Polymerformkörper entfallen daher die bislang notwendigen folgenden Schritte: Beizen, Aktivieren und Erzeugung einer Zwischenschicht (siehe beispielsweise "Kunststoffgalvanisierung", LPW-Taschenbuch für Galvanotechnik, Band 1, Verfahrenstechnik, 13. Ausgabe 1988, Seiten 443 bis 449). Erfindungsgemäß kann daher beispielsweise nach der Reinigung der Oberfläche des Polymerformkörpers der Schichtaufbau direkt erfolgen.

Überraschenderweise ist es auch möglich, die erfindungsgemäßen Polymerformkörper mittels badfreier Galvanisierung mit einem Metall zu beschichten. Hier kann auf das übliche Eintauchen der zu beschichtenden Werkstücke in elektrolytgefüllte Behälter, die so genannten Galvanisierbäder, verzichtet werden. Stattdessen werden die benötigten Elektrolyte von saugfähigen Materialien aufgenommen, die wiederum von Beschichtungswerkzeugen gehalten werden. Durch Anpressen der Werkzeuge an die zu beschichtende Oberfläche, insbesondere Bauteiloberfläche, wird die Abscheidung ermöglicht, wobei der benötigte Gleichstrom ebenfalls vom Werkzeug übertragen wird.

Hierbei wird die Leiterplatte mit den leitfähigen Strukturen auf übliche Weise in ein elektrolytisches Galvanisierungsbad eingebracht (siehe beispielsweise "Kunststoffgalvanisierung", LPW-Taschenbuch für Galvanotechnik, Band 1, Verfahrenstechnik, 13. Ausgabe 1988, Seiten 443 bis 449). Das Galvanisierbad enthält beispielsweise eine Kupfer(II)-sulfat-Lösung mit einer Anode. Durch das Anlegen einer negativen Spannung (Kathode) an die elektrisch leitfähigen Strukturen auf der Oberfläche der Polymerformkörpern sowie an die Gegenelektrode aus Kupfer kann gezielt Kupfer aus der Lösung auf den Strukturen abgeschieden werden und eine metallische Schicht bilden. Die hierzu geeigneten Elektrolytlösungen, das elektrische Spannungspotential sowie die geeignete Dauer der Abscheidung kann vom Fachmann je nach Anwendung und gewünschter Eigenschaft der Leiterbahnen gewählt werden. Überraschenderweise führt die Verwendung der erfindungsgemäßen CNT-Mengen zu einer gezielten Abscheidung des Kupfers auf den bereits vorhandenen leitfähigen Strukturen mit erhöhter CNT-Konzentration auf der Oberfläche des Polymerformkörpers. Bei der Verwendung der erfindungsgemäßen CNT-Anteile in dem Polymerformkörpern entsteht an den Stellen der Oberfläche des Polymerformkörpers, die nicht thermisch behandelt wurden und daher keine leitfähigen Strukturen enthalten, kein zur Abscheidung von Kupfer ausreichend hohes Spannungspotential. Demgegenüber kann es bei Verwendung höherer CNT-Anteile in den Polymerformkörpern zu einer ungezielten Abscheidung von Kupfer auf der gesamten Oberfläche des Polymerformkörpers kommen. Andererseits ist die erfindungsgemäße Mindestmenge an CNT im Polymerformkörper notwendig, um leitfähige Strukturen zu erzeugen, die ein ausreichend hohes Spannungspotential zur Abscheidung des Kupfers auf den leitfähigen Strukturen ermöglichen.

Mit dem erfindungsgemäßen Verfahren wird es auf einfache Weise möglich, leitfähige Strukturen auf einer Leiterplatte zu erzeugen, ohne dass beispielsweise das Abdecken von Bereichen, die nicht mit Kupfer beschichtet werden sollen, notwendig ist. Da das Kupfer gezielt auf die bereits vorhandenen leitfähigen Strukturen aufgebracht wird, muss zudem anschließend auch kein Ätzprozess zum Entfernen von überschüssigem Kupfer durchgeführt werden.

Eine erfindungsgemäß bevorzugte Leiterplatten-Anordnung umfasst mindestens eine Leiterplatte mit mindestens einer elektrisch leitfähigen Leiterbahn, wobei die Leiterplatte einen Polymerformkörper mit 0,1-10 Gew.-% Carbon Nanotubes (CNT), bezogen auf die Masse der Polymerphase/n, aufweist, und die mindestens eine elektrisch leitfähige Leiterbahn eine Kupferschicht aufweist. Der Begriff "Kupfer" (bzw. "Zinn" bzw. "Gold")umfasst im Rahmen der vorliegenden Anmeldung sowohl reines Kupfer (bzw. Zinn bzw. Gold), übliche Verunreinigungen aufweisendes Kupfer (bzw. Zinn bzw. Gold), sowie Legierungen und Zusammensetzungen, die Kupfer (bzw. Zinn bzw. Gold), beispielsweise mindestens 20 Gew.-%, insbesondere mindestens 90 Gew.-% Kupfer (bzw. Zinn bzw. Gold), weiter insbesondere mindestens 98 Gew.-% Kupfer (bzw. Zinn bzw. Gold), bezogen auf das Gesamtgewicht der Legierung oder Zusammensetzung, aufweisen.

Optional kann die Kupferschicht vollständig oder abschnittsweise mit einer weiteren Schicht, die ein oder mehrere Metalle oder Legierungen umfasst oder aus diesen besteht, versehen sein. Insbesondere kann die Kupferschicht eine Zinn oder Gold umfassende Schicht aufweisen, insbesondere verzinnt oder vergoldet sein. Eine Zinn oder Gold umfassende Schicht kann insbesondere an Stellen angeordnet sein, auf denen Abschnitte des anzubringenden Bauelements, vorzugsweise SMD-Anschlüsse, angeordnet werden.

Des Weiteren ist es bevorzugt, dass die Leiterplatten-Anordnung mindestens ein elektronisches Bauelement aufweist, das durch eine erfindungsgemäße organische Klebstoff-Zusammensetzung, wie sie nachfolgend beschrieben wird, und/oder durch Herstellen einer Bindung, die Carbon Nanotubes (CNT) enthaltendes Material umfasst, und/oder durch Herstellen einer Lötverbindung, mit mindestens einer elektrisch leitfähigen Leiterbahn der Leiterplatte verbunden ist. Durch die Lötverbindung kann eine Verbindung zwischen einem Bauelement, insbesondere zwischen mindestens einem Abschnitt eines Bauelements, vorzugsweise zwischen mindestens einem Abschnitt, z.B. mindestens einem Anschluss, eines SMDs, und dem Polymerformkörper, hergestellt werden. Insbesondere kann die Lötverbindung das Bauelement mit einer Schicht, die Metall, insbesondere Kupfer umfasst, die auf den leitfähigen Strukturen mit erhöhter CNT-Konzentration auf der Oberfläche des Polymerformkörpers, beispielsweise wie vorstehend beschrieben, aufgebracht wurde, verbinden. Als Lötverfahren können hierzu beispielsweise dem Fachmann bekannte Verfahren, insbesondere Reflow-Verfahren, verwendet werden.

Die Erfindung betrifft auch ein Verfahren zur Herstellung einer erfindungsgemäßen Leiterplatten-Anordnung gemäß Anspruch 11, umfassend die Schritte:
a) Bereitstellen eines Polymerformkörpers aus mindestens einer Polymerphase die Carbon Nanotubes (CNT) enthält,
b) Thermisches Behandeln mindestens einer Oberfläche des Polymerformkörpers zur Erzeugung der leitfähigen Strukturen auf der Oberfläche des Polymerformkörpers, wobei die thermische Behandlung ein Erhitzen auf eine Temperatur umfasst, die mindestens der Schmelztemperatur der mindestens einen Polymerphase entspricht, und
c) Optionales Galvanisieren der elektrisch leitfähigen Strukturen. Wenn erwünscht, kann auch nur ein Galvanisieren von Teilbereichen der elektrisch leitfähigen Strukturen erfolgen.

Zusätzlich bevorzugt wird in dem Verfahren zur Herstellung einer erfindungsgemäßen Leiterplatten-Anordnung in einem zusätzlichen Schritt d) mindestens ein elektronisches Bauteil oder Bauelement unter Verwendung einer erfindungsgemäßen Klebstoffzusammensetzung mit mindestens einer Leiterbahn der Leiterplatte und/oder durch Herstellen einer Bindung, die Carbon Nanotubes (CNT) enthaltendes Material umfasst, mit mindestens einer Leiterbahn der Leiterplatte verbunden, und/oder durch Herstellen einer Lötverbindung, mit mindestens einer Leiterbahn der Leiterplatte verbunden, insbesondere elektrisch und/oder thermisch leitfähig verbunden.

Nach einem weiteren Aspekt der vorliegenden Erfindung können bei der Herstellung des erfindungsgemäßen Polymerformkörpers, z.B. durch Spritzguss, erhabene oder vertiefte Bereiche vorgesehen sein, die z.B. als Leiterbahnen oder auch zur Befestigung von Bauelementen dienen können. Solche Bereiche können beispielsweise als Klemmen, Clips, Bohrungen oder dergleichen ausgebildet sein und ein einfaches Befestigen bzw. Einklemmen der Bauteile ermöglichen. Weiter bevorzugt kann dann der zur Befestigung genutzte Bereich des Polymerformkörpers direkt oder indirekt erhitzt werden, um die vorstehend beschriebene (leitfähige) Bindung zwischen dem Polymerformköper bzw. einem Bereich davon und dem Bauteil zu erzeugen.

Nach einem weiteren Aspekt der Erfindung umfasst der Polymerformkörper mindestens eine Polymerphase mit Carbon Nanotubes (CNT), wobei der Polymerformkörper auf der Oberfläche elektrisch oder thermisch leitfähige Strukturen aufweist, wobei die Konzentration der CNT in den Bereichen der elektrisch leitfähigen Oberflächenstrukturen höher ist als in den nicht elektrisch leitfähigen Oberflächenbereichen, wobei die nicht elektrisch leitfähigen Oberflächenbereiche CNTs enthalten. Hierbei umfasst der Ausdruck "Konzentration der CNT in den Bereichen der elektrisch leitfähigen Oberflächenstrukturen" bzw. "nicht elektrisch leitfähigen Oberflächenbereichen" dass die äußere Oberflächenschicht bis zu einer Tiefe von 10 µm, bevorzugt bis zu 1 µm, auf den CNT-Gehalt hin untersucht wird.

### METHODEN

Zur Bestimmung der Parameter der erfindungsgemäßen Polymerformkörper werden die nachstehenden Methoden eingesetzt:

Die Bestimmung der elektrischen Oberflächenleitfähigkeit erfolgte anhand der Messung des Oberflächenwiderstands mit einem Ohmmeter "Metra Hit Plus" der Firma Gossen Metrawatt GmbH nach Angaben des Herstellers. Es wurde sowohl der Widerstand auf der unbehandelten Oberfläche als auch jeweils an verschiedenen Stellen der mit dem Laser behandelten Oberflächenausschnitte mittels zweier Elektroden im Abstand von 2 mm gemessen. Zum Vergleich wurde die Oberfläche an einer Stelle mechanisch abgetragen und der elektrische Widerstand im Material gemessen.

Die Analyse ob ein Polymerformkörper getrennte Polymerphasen aufweist kann unter Verwendung der Differential-Scanning-Calorimetry (DSC) nach DIN EN ISO 11357 erfolgen. Hierbei kann die Zahl der Polymerphasen anhand der Phasenübergänge beim Schmelzen des Polymerformkörpers festgestellt werden.

Die Bestimmung der Schmelztemperatur der Polymerphasen bzw. des Polymerformkörpers kann gemäß DIN EN ISO 3146 erfolgen.

Der Gesamtgehalt an CNT im Polymerformkörper kann durch das pyrolytische Messverfahren gemäß DIN EN ISO 3451 bestimmt werden.

### BEISPIELE

### 1. Herstellung eines Polymerformkörpers mit leitfähigen Strukturen

Es wird eine Polymermischung aus 75 % Polypropylen (Repol HP-12 der Firma Reliance, Indien), 3,75 % CNT (Baytubes C 150 P, Fa. Bayer) und 21,25 Gew.-% Polycarbonat (Makrolon 2805, Fa. Bayer) hergestellt.

Die Mischung wird in einem ZSE 27/44D Doppelschneckenextruder der Firma Leistritz, Nürnberg mit einem Durchmesser von 27 mm und einem Verhältnis L/D von 44 bei einem Durchsatz von 10 kg/h mit einer Leistung von 18 kWh aufgeschmolzen und vermengt. Im Extruder wurde ein von 200°C auf 260°C ansteigendes Temperaturprofil eingestellt. Anschließend erfolgte eine Granulierung.

Der Polymerformkörper wurde im Spritzgussverfahren (Gerätetyp: Arburg 270) bei einer Temperatur von 220-240°C in der Form von runden Plattchen mit 4 cm Durchmesser ausgeformt. Für die thermische Behandlung wurde ein CO₂-Laser verwendet. Die Messwerte der Oberflächenwiderstände sind in der nachfolgenden Tabelle angegeben.

**Tabelle:**

| **Messstelle** | **Oberflächenwiderstand** | | | **Mittelwert** | **Maßeinheit** |
|---|---|---|---|---|---|
| unbehandelt | keine Leitfähigkeit (> 10 MOhm) | | | | |
| Laserspur 2 | 133 | 122 | 146 | 1,34 | kOhm |
| Laserspur 3 | 64,3 | 58,9 | 69,1 | 64,1 | kOhm |
| Laserspur 4 | 23,2 | 21,2 | 24,4 | 22,9 | kOhm |
| abgeschliffen | keine Leitfähigkeit (> 10 MOhm) | | | | |

### 2. Herstellung einer Leiterplatten-Anordnung mit elektronischen Bauteilen

### Beispiel a)

Zunächst wird eine erfindungsgemäße Klebstoff-Zusammensetzung hergestellt. Diese besteht aus 35g Photobond PB 437 (Hersteller: Delo, Deutschland), 0,35g Nanocyl 7000 (Hersteller: Nanocyl, Belgien). Die Komponenten der Klebstoff-Zusammensetzung werden für 20 min bei 45°C unter Verwendung einer Heizplatte IKA RH-KT/C mit einem Rührer (Heidolph RZ RO/4) bei 300 U/min gerührt.

Der Kleber wurde zur Bestimmung des elektrischen Widerstands auf eine nicht leitende Oberfläche aufgebracht und unter einer UV-Lampe (Siemens UV Lampe 6ES5985-1AA11) für 7 min ausgehärtet. Anschließend wurde mit dem Messgerät Messcontrol M-860 D ein Widerstand von 57 Ohm/cm gemessen.

Um eine Diode auf eine Leiterplatte aufzubringen, wurden die Metallbeinchen der Diode in die Klebstoff-Zusammensetzung eingetaucht und die Dioden in Kontakt mit der Leiterplatte gebracht, so dass der Klebertropfen eine Verbindung zwischen der Leiterbahn und den Beinchen herstellt. Durch Aushärten mit der UV-Lampe ergab sich eine feste Verbindung. Nach Anlegen einer Spannung von 50V leuchtete die Diode.

### Beispiel b)

Um eine Diode auf eine einen Carbon Nanotubes enthaltenden Polymerformkörper aufweisende Leiterplatte aufzubringen, wurde die Diode in Kontakt mit der Leiterplatte gebracht, und mit einem Laser wurden eine oder mehrere einem Beinchen der Diode benachbarte Stellen des Polymerformkörpers angeschmolzen, so dass Schmelze eine Verbindung zwischen der Leiterbahn und den Beinchen herstellt. Nach Abkühlen auf 20°C ergab sich eine mechanisch belastbare und elektrisch leitfähige Bindung.

Die erfindungsgemäßen Polymerformkörper können für die erfindungsgemäßen Leiterplatten-Anordnungen verwendet werden. Das erfindungsgemäß verwendete Gerät ist zur thermischen Behandlung der Oberfläche des Polymerformkörpers geeignet (Schritt b des Verfahrens zur Erzeugung leitfähiger Strukturen).

Weiter offenbart wird nachfolgend:
1. Verfahren zur Erzeugung leitfähiger Strukturen auf der Oberfläche von nicht oder nur gering leitfähigen Polymerformkörpern, umfassend die folgenden Schritte:
   a) Bereitstellen eines Polymerformkörpers aus mindestens einer Polymerphase, die Carbon Nanotubes (CNT) enthält;
   b) thermische Behandlung mindestens einer Oberfläche des Polymerformkörpers, insbesondere einer Oberfläche der CNT-enthaltenden Polymerphase, die eine Oberfläche des Polymerformkörpers bildet, zur Erzeugung der leitfähigen Strukturen auf der Oberfläche des Polymerformkörpers, wobei die thermische Behandlung ein Erhitzen auf eine Temperatur umfasst, die mindestens der Schmelztemperatur der mindestens einen Polymerphase entspricht.

   Bevorzugterweise ist ein Verfahren gemäß Punkt 1, dadurch gekennzeichnet, dass die Polymerphase/n durch Vermischen von geschmolzenem Polymer mit 0,1-10 Gew.-% Carbon Nanotubes, bezogen auf die Masse der Polymerphase/n, erhalten wird/werden.
2. Verfahren gemäß Punkt 1, dadurch gekennzeichnet, dass die Polymerphase/n durch Vermischen von geschmolzenem Polymer mit 0,1-10 Gew.-% Carbon Nanotubes, bezogen auf die Masse der Polymerphase/n, erhalten wird/werden.
3. Verfahren gemäß Punkt 1 oder 2, dadurch gekennzeichnet, dass der Polymerformkörper durch Verschmelzen mindestens einer Polymerphase, die Carbon Nanotubes (CNT) in einem Anteil zwischen 1 und 40 Gew.-% enthält, mit mindestens einer weiteren Polymerphase mit geringerem Carbon Nanotubes (CNT)-Anteil, erhalten wird.
4. Verfahren gemäß einem der vorhergehenden Punkte, dadurch gekennzeichnet, dass die Polymerphase, die Carbon Nanotubes (CNT) in einem Anteil zwischen 1 und 40 Gew.-% enthält, ein oder mehrere Polymer/e umfasst, ausgewählt aus der Gruppe bestehend aus Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA 6.4), Polyamid 12 (PA 12), aromatischem Polyamid und Polysulfon.
5. Verfahren gemäß einem der vorhergehenden Punkte, dadurch gekennzeichnet, dass die thermische Behandlung der Oberfläche/n des Polymerformkörpers durch Kontakt mit einem erhitzten Körper, Gas oder Flüssigkeit, oder durch elektromagnetische Strahlung erfolgt.
6. Verfahren gemäß einem der vorhergehenden Punkte, dadurch gekennzeichnet, dass als elektromagnetische Strahlung Laserstrahlung oder IR-Strahlung verwendet wird.
7. Polymerformkörper, umfassend mindestens eine Polymerphase mit Carbon Nanotubes (CNT), wobei der Polymerformkörper auf der Oberfläche elektrisch oder thermisch leitfähige Strukturen aufweist, wobei die Konzentration der CNT in den Bereichen der elektrisch leitfähigen Oberflächenstrukturen höher ist als in den nicht elektrisch leitfähigen Oberflächenbereichen. Bevorzugterweise umfasst der Polymerformkörper mindestens eine Polymerphase mit Carbon Nanotubes (CNT), wobei der Polymerformkörper auf der Oberfläche elektrisch oder thermisch leitfähige Strukturen aufweist, wobei die Konzentration der CNT in den Bereichen der elektrisch leitfähigen Oberflächenstrukturen höher ist als in den nicht elektrisch leitfähigen Oberflächenbereichen, wobei die nicht elektrisch leitfähigen Oberflächenbereiche CNTs enthalten. Hierbei umfasst der Ausdruck "Konzentration der CNT in den Bereichen der elektrisch leitfähigen Oberflächenstrukturen" bzw. "nicht elektrisch leitfähigen Oberflächenbereichen" dass die äußere Oberflächenschicht bis zu einer Tiefe von 10 µm, bevorzugt bis zu 1 µm, auf den CNT-Gehalt hin untersucht wird.
8. Polymerformkörper gemäß Punkt 7, dadurch gekennzeichnet, dass mindestens eine Polymerphase ein Polymer enthält, ausgewählt aus der Gruppe bestehend aus: Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA 6.4), Polyamid 12 (PA 12), aromatischem Polyamid und Polysulfon.
9. Polymerformkörper gemäß einem der Punkte 7 oder 8, dadurch gekennzeichnet, dass zwischen 0,01 und 10 Gew.-% CNT, bezogen auf die Gesamtmasse der Polymerphase/n des Polymerformkörpers, enthalten sind.
10. Polymerformkörper gemäß einem der Punkte 7 bis 9, dadurch gekennzeichnet, dass der Polymerformkörper mindestens zwei getrennte Polymerphasen enthält.
11. Polymerformkörper gemäß einem der Punkte 7 bis 10, dadurch gekennzeichnet, dass eine der Polymerphasen einen höheren Anteil an Carbon Nanotubes (CNT) als die andere/n Phasen aufweist.
12. Polymerformkörper gemäß einem der vorstehenden Punkte, wobei für den Polymerformkörper eine Polymerblend aus Polycarbonat mit Polyolefin, insbesondere mit Polypropylen oder Polyethylen, verwendet wird.
13. Verfahren gemäß Punkt 1, worin die die Polymerphase/n durch Vermischen von geschmolzenem Polymer mit 0,1-10 Gew.-% Carbon Nanotubes, bezogen auf die Masse der Polymerphase/n, erhalten wird/werden.
14. Gerät zum Erzeugen einer Struktur an einem zu bearbeitenden Körper, gekennzeichnet durch eine Energiequelle mit mindestens einer Elektrode, die zum Abgeben einer Energie vorgesehen ist, mit welcher der zu bearbeitenden Körper wenigstens teilweise erwärmbar ist. Bevorzugterweise dient das Gerät zur thermischen Behandlung der Oberfläche von Polymerformkörpern, wobei an den thermisch behandelten Stellen definierte elektrisch leitfähige Strukturen entstehen.
15. Gerät nach Punkt 14, dadurch gekennzeichnet, dass der zu bearbeitende Körper ein Polymerformkörper aus mindestens einer Polymerphase ist, die Carbon-Nanotubes enthält.
16. Gerät nach Punkt 14 oder 15, dadurch gekennzeichnet, dass die Energiequelle eine elektrische Energiequelle ist.
17. Gerät nach Punkt 16, dadurch gekennzeichnet, dass die Energiequelle mindestens zwei Elektroden aufweist, die an den zu bearbeitenden Körper anlegbar sind, wobei mit den zwei Elektroden ein Strom durch den zu bearbeitenden Körper leitbar ist, der den zu bearbeitenden Körper aufwärmt.
18. Gerät nach Punkt 16 oder 17, dadurch gekennzeichnet, dass die elektrische Energiequelle eine Spannungsquelle vorzugsweise mit einer Leerlaufspannung größer als 500V und insbesondere mit einer Leerlaufspannung von 1000V ist.
19. Gerät nach einem der vorstehenden Punkte, dadurch gekennzeichnet, dass die zu erzeugende Struktur ein elektronischer Schaltkreis ist.
20. Gerät nach einem der vorstehenden Punkte, dadurch gekennzeichnet, dass die erste Elektrode und die zweite Elektrode in einer Ebene oder in zwei verschiedenen Ebenen des zu bearbeitenden Körpers angeordnet sind.
21. Gerät nach einem der vorstehenden Punkte, dadurch gekennzeichnet, dass der Abstand zwischen der ersten und zweiten Elektrode weniger als 1mm ist.
22. Gerät nach einem der vorstehenden Punkte, gekennzeichnet durch einen Abstandshalter, der die erste und zweite Elektrode miteinander verbindet.
23. Vorrichtung zum Erzeugen einer Struktur auf einem zu bearbeitenden Körper mit dem zu bearbeitenden Körper und einem Gerät, nach einem der Punkte 1-9, das den zu bearbeitenden Körper wenigstens teilweise erwärmt.
24. Plotter mit einer Vorrichtung nach einem der vorstehenden Punkte.
25. Matrixdrucker mit einer Vorrichtung nach einem der vorstehenden Punkte als Druckmatrix.
26. Stift mit einer Vorrichtung nach einem der vorstehenden Punkte als Stiftspitze.
27. Verfahren zum Erzeugen einer Struktur auf einem zu bearbeitenden Körper, dadurch gekennzeichnet, dass zwischen zwei verschiedenen Punkten des zu bearbeitenden Körpers eine elektrische Energie geleitet wird.
28. Leiterplatten-Anordnung, umfassend mindestens eine Leiterplatte mit mindestens einer elektrisch leitfähigen Leiterbahn und mindestens einem elektronischen Bauelement, wobei die Leiterplatte einen Polymerformkörper mit 0,1-10 Gew.-% Carbon Nanotubes (CNT), bezogen auf die Masse der Polymerphase/n, umfasst, und wobei das mindestens eine elektronische Bauelement durch eine organische Klebstoff-Zusammensetzung enthaltend 0,05-10 Gew.% Carbon-Nanotubes (CNT), bezogen auf die Masse der Klebstoff-Zusammensetzung, und/oder durch eine Bindung, die Carbon Nanotubes (CNT) enthaltendes Material, insbesondere eine oder mehrere Carbon Nanotubes (CNT) enthaltende Polymerphasen, umfasst, und/oder durch eine Lötverbindung mit mindestens einer elektrisch leitfähigen Leiterbahn der Leiterplatte verbunden ist.
29. Leiterplatten-Anordnung gemäß Punkt 28, wobei die organische Klebstoff-Zusammensetzung einen Widerstand von weniger als 100 Ohm, insbesondere weniger als 50 Ohm aufweist.
30. Leiterplatten-Anordnung gemäß einem der vorstehenden Punkte, wobei die organische Klebstoff-Zusammensetzung mindestens einen Klebstoff enthält, der ausgewählt ist aus der Gruppe bestehend aus: Acrylat-Klebstoffen, Phenol-Formaldehydharz-Klebstoffen, Silicon-Klebstoffen, und Polyurethan-Klebstoffen, bevorzugterweise enthält die Klebstoff-Zusammensetzung einen Urethanacrylat-Klebstoff.
31. Leiterplatten-Anordnung gemäß einem der vorangegangenen Punkte, wobei die Verbindung zwischen der mindestens einen elektrisch leitfähigen Leiterbahn und dem mindestens einen elektronischen Bauelement elektrisch leitfähig ist und einen Widerstand von weniger als 100 Ohm aufweist.
32. Klebstoff-Zusammensetzung enthaltend 0,05-10 Gew.% Carbon-Nanotubes (CNT).
33. Klebstoff-Zusammensetzung gemäß Punkt 32, wobei die Klebstoff-Zusammensetzung mindestens einen Klebstoff enthält, der ausgewählt ist aus der Gruppe bestehend aus: Acrylat-Klebstoffen, Phenol-Formaldehydharz-Klebstoffen, Silicon-Klebstoffen, und Polyurethan-Klebstoffen, bevorzugterweise enthält die Klebstoff-Zusammensetzung einen Urethanacrylat-Klebstoff.
34. Klebstoff-Zusammensetzung gemäß einem der vorstehenden Punkte, wobei die organische Klebstoff-Zusammensetzung einen Widerstand von weniger als 100 Ohm, insbesondere weniger als 50 Ohm aufweist.
35. Verfahren zum Aufbringen mindestens eines elektronischen Bauelements auf eine Leiterplatte umfassend die folgenden Schritte:
   a) Bereitstellen einer Leiterplatte mit mindestens einer elektrisch leitfähigen Leiterbahn oder mindestens einem elektrisch leitfähigen Bereich, wobei die Leiterplatte einen Polymerformkörper mit 0,1-10 Gew.-% Carbon Nanotubes (CNT), bezogen auf die Masse der Polymerphase/n, aufweist,
   b) Bereitstellen mindestens eines elektronischen Bauelements, und
   c) Verbinden, vorzugsweise thermisch und/oder elektrisch leitfähiges Verbinden, des elektronischen Bauelements mit der mindestens einen elektrisch leitfähigen Leiterbahn oder dem mindestens einen elektrisch leitfähigen Bereich unter Verwendung der Klebstoff-Zusammensetzung gemäß einem der Ansprüche 5 bis 7 und/oder durch Herstellen einer Bindung, die Carbon Nanotubes (CNT) enthaltendes Material, insbesondere eine oder mehrere Carbon Nanotubes (CNT) enthaltende Polymerphasen, umfasst und/oder durch Herstellen einer Lötverbindung.
36. Verfahren nach Punkt 35, wobei die Herstellung der Bindung gemäß Schritt c) umfasst,
   aa) Zuführen von Energie zu mindestens einem Abschnitt, insbesondere einem Oberflächenabschnitt, des Polymerformkörpers oder der elektrisch leitfähigen Bahn oder des elektrisch leitfähigen Bereichs, wobei der Abschnitt zumindest teilweise schmilzt,
   bb) In Kontakt Kommen oder in Kontakt Bringen eines Abschnitts des elektronischen Bauelements mit dem zumindest teilweise geschmolzenen Abschnitt des Polymerformkörpers oder der elektrisch leitfähigen Bahn oder des elektrisch leitfähigen Bereichs,
   cc) Ausbilden oder Ausbilden lassen einer Bindung, insbesondere einer elektrisch leitfähigen Bindung, zwischen dem Abschnitt des elektronischen Bauelements und dem mindestens einen Abschnitt des Polymerformkörpers oder der elektrisch leitfähigen Bahn oder des elektrisch leitfähigen Bereichs.
37. Verfahren nach Punkt 36, wobei der Schritts des Zuführens von Energie zu mindestens einem Abschnitt des Polymerformkörpers oder der elektrisch leitfähigen Bahn oder des elektrisch leitfähigen Bereichs, umfasst,
   i) Erwärmen eines Abschnitts des elektronischen Bauelements, der mit dem Polymerformkörper oder der elektrisch leitfähigen Bahn oder dem elektrisch leitfähigen Bereich in Kontakt steht oder für ein in Kontakt kommen mit dem Polymerformkörper oder der elektrisch leitfähigen Bahn oder dem elektrisch leitfähigen Bereich ausgelegt ist und hiermit nach dem Erwärmen in Kontakt gebracht wird, und/oder
   ii) Erwärmen eines Abschnitts des Polymerformkörpers oder der elektrisch leitfähigen Bahn oder des elektrisch leitfähigen Bereichs.
38. Verfahren gemäß einem der vorstehenden Punkte, wobei der Schritt des Zuführens von Energie gemäß Punkt 36 oder wobei der Schritt des Erwärmens gemäß Punkt 37 unter Verwendung eines Lasers erfolgt.
39. Verfahren gemäß einem der vorstehenden Punkte, wobei die Bindung eine oder mehrere Carbon Nanotubes (CNT) enthaltende Polymerphasen umfasst oder aus diesen besteht.
40. Verfahren nach Punkt 39, wobei das Herstellen der Bindung derart erfolgt, dass die Bindung mindestens eine Carbon Nanotubes (CNT) enthaltende Polymerphase umfasst, wobei vorzugsweise von einem Polymermaterial ausgegangen wird, dass vor der Erhitzung zur Erzeugung der Bindung einen Gehalt von 0,05-10 Gew.-% Carbon Nanotubes (CNT), vorzugsweise von 0,1-10 Gew.-% Carbon Nanotubes (CNT), bevorzugt von 0,2-10 Gew.-% Carbon Nanotubes (CNT), jeweils bezogen auf die Masse des Polymermaterials, aufweist.
41. Verwendung einer Klebstoff-Zusammensetzung gemäß einem der vorstehenden Punkte zum elektrisch leitfähigen Verbinden eines elektronischen Bauelements mit einem anderen elektrisch leitfähigen Bauteil oder Formteil, insbesondere einer elektrisch leitfähigen Leiterbahn oder einem elektrisch leitfähigen Bereich auf einer Leiterbahn.
42. Leiterplatten-Anordnung, umfassend mindestens eine Leiterplatte mit mindestens einer elektrisch leitfähigen Leiterbahn, wobei die Leiterplatte einen Polymerformkörper mit 0,1-10 Gew.-% Carbon Nanotubes (CNT), bezogen auf die Masse der Polymerphase/n, aufweist, und die mindestens eine elektrisch leitfähige Leiterbahn eine Metallschicht, bevorzugt eine Kupferschicht, umfasst.
43. Leiterplatten-Anordnung gemäß Punkt 42, wobei mindestens ein elektronisches Bauelement durch eine organische Klebstoff-Zusammensetzung gemäß einem der Ansprüche 5-7 und/oder durch Herstellen einer Bindung, die Carbon Nanotubes (CNT) enthaltendes Material umfasst, und/oder durch Herstellen einer Lötverbindung mit mindestens einer elektrisch leitfähigen Leiterbahn der Leiterplatte verbunden ist.
44. Verfahren zur Herstellung einer Leiterplatten-Anordnung gemäß einem der vorstehenden Punkte, umfassend die Schritte:
   a) Bereitstellen eines Polymerformkörpers aus mindestens einer Polymerphase die Carbon Nanotubes (CNT) enthält,
   b) Thermisches Behandeln mindestens einer Oberfläche des Polymerformkörpers zur Erzeugung der leitfähigen Strukturen auf der Oberfläche des Polymerformkörpers, wobei die thermische Behandlung ein Erhitzen auf eine Temperatur umfasst, die mindestens der Schmelztemperatur der mindestens einen Polymerphase entspricht, und
   c) Galvanisieren der elektrisch leitfähigen Strukturen mit einem Metall, bevorzugt mit Kupfer.
45. Verfahren zur Herstellung einer Leiterplatten-Anordnung gemäß Punkt 44, wobei in einem zusätzlichen Schritt d) mindestens ein elektronisches Bauteil oder Bauelement unter Verwendung einer Klebstoffzusammensetzung gemäß einem der Ansprüche 5-7 und/oder durch Herstellen einer Bindung, die Carbon Nanotubes (CNT) enthaltendes Material umfasst, und/oder durch Herstellen einer Lötverbindung mit mindestens einer Leiterbahn der Leiterplatte verbunden, insbesondere elektrisch und/oder thermisch leitfähig verbunden, wird.
46. Verfahren gemäß einem der vorstehenden Punkte, worin die Galvanisierung in Schritt c) durch eine badfreie Galvanisierung erfolgt.
47. Insbesondere betrifft die Erfindung einen Polymerformkörper, hergestellt unter Verwendung des erfindungsgemäßen Verfahrens.
48. Verwendung eines Geräts zur Erzeugung leitfähiger Strukturen auf der Oberfläche eines Polymerformkörpers der mindestens eine Polymerphase, die Carbon Nanotubes (CNT) enthält, aufweist, worin das Gerät eine Energiequelle mit mindestens einer Elektrode, die zum Abgeben einer Energie vorgesehen ist, mit welcher der zu bearbeitenden Körper wenigstens teilweise erwärmbar ist, aufweist. Erfindungsgemäß wird die leitfähige Struktur auf der Oberfläche der Polymerphase, die CNTs enthält, erzeugt, wobei die Polymerphase, die CNTs enthält, eine Oberfläche des Polymerformkörpers bildet.

## Patentansprüche

1. Verfahren zur Erhöhung der elektrischen Leitfähigkeit einer Oberfläche eines Polymerformkörpers aus mindestens einer Polymerphase, die Carbon Nanotubes (CNT) enthält, umfassend die folgenden Schritte:
a) Bereitstellen eines Polymerformkörpers aus mindestens einer Polymerphase, die Carbon Nanotubes (CNT) enthält, wobei der Polymerformkörper eine Polyolefin-Beimischung von mindestens 10 Gew.% bezogen auf das Gewicht des Polymerformkörpers umfasst;
b) thermische Behandlung der Oberfläche des Polymerformkörpers zur Erhöhung der elektrischen Leitfähigkeit der behandelten Oberfläche, wobei die thermische Behandlung ein Erhitzen auf eine Temperatur umfasst, die mindestens der Schmelztemperatur der mindestens einen Polymerphase entspricht.

2. Verfahren gemäß Anspruch 1, **dadurch gekennzeichnet, dass** die Polymerphase/n durch Vermischen von geschmolzenem Polymer mit 0,1-10 Gew.-% Carbon Nanotubes, bezogen auf die Masse der Polymerphase/n, erhalten wird/werden.

3. Verfahren gemäß Anspruch 1 oder 2, **dadurch gekennzeichnet, dass** der Polymerformkörper durch Verschmelzen mindestens einer Polymerphase, die Carbon Nanotubes (CNT) in einem Anteil zwischen 1 und 40 Gew.-% enthält, mit mindestens einer weiteren Polymerphase mit geringerem Carbon Nanotubes (CNT)-Anteil, erhalten wird.

4. Verfahren gemäß einem der vorhergehenden Ansprüche, **dadurch gekennzeichnet, dass** die Polymerphase mindestens ein Polyolefin, insbesondere ein cyclisches Polyolefin enthält oder daraus besteht; und/oder mindestens einen lichtleitenden Zusatz und/oder einen wärmeleitenden Zusatz mit einer Leitfähigkeit von mehr als 20 W/mK und/oder Treibmittel enthält.

5. Verfahren gemäß einem der vorhergehenden Ansprüche, **dadurch gekennzeichnet, dass** die thermische Behandlung der Oberfläche/n des Polymerformkörpers durch Kontakt mit einem erhitzten Körper, Gas oder Flüssigkeit, oder durch elektromagnetische Strahlung, insbesondere Laserstrahlung oder IR-Strahlung, erfolgt.

6. Polymerformkörper mit leitfähigen Strukturen auf der Oberfläche, wobei der Polymerformkörper eine Polyolefin-Beimischung von mindestens 10 Gew.% bezogen auf das Gewicht des Polymerformkörpers umfasst, hergestellt unter Verwendung des Verfahrens gemäß einem der Ansprüche 1-5.

7. Polymerformkörper gemäß Anspruch 6, wobei der Polymerformkörper auf der Oberfläche elektrisch oder thermisch leitfähige Strukturen aufweist, wobei die Konzentration der CNT in den Bereichen der durch thermische Behandlung erzeugten elektrisch leitfähigen Oberflächenstrukturen höher ist als in den nicht elektrisch leitfähigen Oberflächenbereichen, wobei die nicht elektrisch leitfähigen Oberflächenbereiche CNTs enthalten.

8. Polymerformkörper gemäß Anspruch 6 oder 7, wobei für den Polymerformkörper eine Polymerblend aus Polycarbonat mit Polyolefin, insbesondere mit Polypropylen oder Polyethylen, verwendet wird.

9. Leiterplatten-Anordnung, umfassend mindestens eine Leiterplatte, wobei die Leiterplatte einen Polymerformkörper gemäß Anspruch 6 oder 7 darstellt, mit mindestens einer elektrisch leitfähigen Leiterbahn, wobei die Leiterplatte einen Polymerformkörper mit 0,1-10 Gew.-% Carbon Nanotubes (CNT), bezogen auf die Masse der Polymerphase/n, aufweist, und
a) die mindestens eine elektrisch leitfähige Leiterbahn eine Metallschicht, bevorzugt eine Kupferschicht, umfasst; und/ oder
b) mindestens ein elektronisches Bauelement umfasst, und wobei das mindestens eine elektronische Bauelement durch eine organische Klebstoff-Zusammensetzung enthaltend 0,05-10 Gew.% Carbon-Nanotubes (CNT), bezogen auf die Masse der Klebstoff-Zusammensetzung, und/oder durch eine Bindung, die Carbon Nanotubes (CNT) enthaltendes Material, insbesondere eine oder mehrere Carbon Nanotubes (CNT) enthaltende Polymerphasen, umfasst, und/oder durch eine Lötverbindung mit mindestens einer elektrisch leitfähigen Leiterbahn der Leiterplatte verbunden ist.

10. Leiterplatten-Anordnung gemäß Anspruch 9, wobei die organische Klebstoff-Zusammensetzung mindestens einen Klebstoff enthält, der ausgewählt ist aus der Gruppe bestehend aus: Acrylat-Klebstoffen, Phenol-Formaldehydharz-Klebstoffen, Silicon-Klebstoffen, und Polyurethan-Klebstoffen, bevorzugterweise enthält die Klebstoff-Zusammensetzung einen Urethanacrylat-Klebstoff.

11. Verfahren zur Herstellung einer Leiterplatten-Anordnung gemäß Anspruch 9 oder 10, umfassend die Schritte:
a) Bereitstellen eines Polymerformkörpers aus mindestens einer Polymerphase die Carbon Nanotubes (CNT) enthält, wobei der Polymerformkörper eine Polyolefin-Beimischung von mindestens 10 Gew.% bezogen auf das Gewicht des Polymerformkörpers umfasst,
b) Thermisches Behandeln mindestens einer Oberfläche des Polymerformkörpers zur Erzeugung der leitfähigen Strukturen auf der Oberfläche des Polymerformkörpers, wobei die thermische Behandlung ein Erhitzen auf eine Temperatur umfasst, die mindestens der Schmelztemperatur der mindestens einen Polymerphase entspricht, und
c) Galvanisieren der elektrisch leitfähigen Strukturen mit einem Metall, bevorzugt mit Kupfer, und/oder
d) Bereitstellen mindestens eines elektronischen Bauelements, und
e) Verbinden, vorzugsweise thermisch und/oder elektrisch leitfähiges Verbinden, des elektronischen Bauelements mit der mindestens einen elektrisch leitfähigen Leiterbahn oder dem mindestens einen elektrisch leitfähigen Bereich unter Verwendung der Klebstoff-Zusammensetzung enthaltend 0,05-10 Gew.-% Carbon-Nanotubes (CNT) und/oder durch Herstellen einer Bindung, die Carbon Nanotubes (CNT) enthaltendes Material, insbesondere eine oder mehrere Carbon Nanotubes (CNT) enthaltende Polymerphasen, umfasst und/oder durch Herstellen einer Lötverbindung.

12. Verfahren nach Anspruch 11, wobei die Herstellung der Bindung gemäß Schritt e) umfasst,
aa) Zuführen von Energie zu mindestens einem Abschnitt, Insbesondere einem Oberflächenabschnitt, des Polymerformkörpers oder der elektrisch leitfähigen Bahn oder des elektrisch leitfähigen Bereichs, wobei der Abschnitt zumindest teilweise schmilzt,
bb) In Kontakt Kommen oder in Kontakt Bringen eines Abschnitts des elektronischen Bauelements mit dem zumindest teilweise geschmolzenen Abschnitt des Polymerformkörpers oder der elektrisch leitfähigen Bahn oder des elektrisch leitfähigen Bereichs,
cc) Ausbilden oder Ausbilden lassen einer Bindung, insbesondere einer elektrisch leitfähigen Bindung, zwischen dem Abschnitt des elektronischen Bauelements und dem mindestens einen Abschnitt des Polymerformkörpers oder der elektrisch leitfähigen Bahn oder des elektrisch leitfähigen Bereichs.

13. Verfahren nach Anspruch 12, wobei der Schritts des Zuführens von Energie zu mindestens einem Abschnitt des Polymerformkörpers oder der elektrisch leitfähigen Bahn oder des elektrisch leitfähigen Bereichs, umfasst,
i) Erwärmen eines Abschnitts des elektronischen Bauelements, der mit dem Polymerformkörper oder der elektrisch leitfähigen Leiterbahn bzw. dem elektrisch leitfähigen Bereich in Kontakt steht oder für ein in Kontakt kommen mit dem Polymerformkörper oder der elektrisch leitfähigen Leiterbahn bzw. dem elektrisch leitfähigen Bereich ausgelegt ist und hiermit nach dem Erwärmen in Kontakt gebracht wird, und/oder
ii) Erwärmen eines Abschnitts des Polymerformkörpers oder der elektrisch leitfähigen Leiterbahn oder des elektrisch leitfähigen Bereichs.

14. Verfahren nach einem der Ansprüche 12 oder 13, wobei der Schritt des Zuführens von Energie gemäß Anspruch 12 oder wobei der Schritt des Erwärmens gemäß Anspruch 13 unter Verwendung eines Lasers erfolgt.

15. Verwendung einer Klebstoff-Zusammensetzung enthaltend Carbon-Nanotubes (CNTs) zum Anbringen von elektronischen Bauelementen auf einem Polymerformkörper gemäß Anspruch 6 oder 7, wobei der Polymerformkörper eine Polyolefin-Beimischung von mindestens 10 Gew.% bezogen auf das Gewicht des Polymerformkörpers umfasst;.

16. Verwendung eines Geräts zur Erzeugung leitfähiger Strukturen auf der Oberfläche eines Polymerformkörpers der mindestens eine Polymerphase, die Carbon Nanotubes (CNT) enthält, aufweist, wobei der Polymerformkörper eine Polyolefin-Beimischung von mindestens 10 Gew.% bezogen auf das Gewicht des Polymerformkörpers umfasst. worin das Gerät eine Energiequelle mit mindestens einer Elektrode aufweist, die zum Abgeben einer Energie vorgesehen ist, mit welcher der zu bearbeitende Körper wenigstens teilweise erwärmbar ist, wobei die leitfähigen Strukturen auf der Oberfläche durch gezieltes Anschmelzen der Oberfläche erzeugt werden.

## Claims

1. A method for increasing the electrical conductivity of a surface of a shaped polymer body of at least one polymer phase containing carbon nanotubes (CNT), comprising the following steps:
a) providing a shaped polymer body of at least one polymer phase containing carbon nanotubes (CNT), wherein the shaped polymer body comprises a polyolefin admixture of at least 10 % by weight, based on the weight of the shaped polymer body;
b) thermally treating the surface of the shaped polymer body for increasing the electrical conductivity of the treated surface, wherein the thermal treatment comprises heating to a temperature which is equal to or higher than the melting temperature of the at least one polymer phase.

2. The method according to claim 1, **characterized in that** the polymer phase(s) is/are obtained by mixing of molten polymer with 0.1-10 % by weight of carbon nanotubes, based on the mass of the polymer phase(s).

3. The method according to claim 1 or 2, **characterized in that** the shaped polymer body is obtained by melting together of at least one polymer phase containing carbon nanotubes (CNT) in a proportion of between 1 and 40 % by weight with at least one further polymer phase with a proportion of carbon nanotubes (CNT) which is lower.

4. The method according to one of the preceding claims, **characterized in that** the polymer phase contains or consists of at least one polyolefin, in particular a cyclic polyolefin; and/or contains at least one light-conducting additive and/or one heat-conducting additive with a conductivity of higher than 20 W/mK and/or a blowing agent.

5. The method according to one of the preceding claims, **characterized in that** the thermal treatment of the surface(s) of the shaped polymer body is conducted by contacting with a heated body, gas or liquid or by electromagnetic radiation, in particular laser radiation or IR radiation.

6. A shaped polymer body with conductive structures on the surface, wherein the shaped polymer body comprises a polyolefin admixture of at least 10 % by weight, based on the weight of the shaped polymer body, produced using the method according to one of claims 1-5.

7. The shaped polymer body according to claim 6, wherein the shaped polymer body comprises electrically or thermally conductive structures on the surface, wherein the concentration of the CNT in the regions of the electrically conductive surface structures which have been created by thermal treatment is higher than that in the surface regions being not electrically conductive, wherein the surface regions being not electrically conductive contain CNTs.

8. The shaped polymer body according to claim 6 or 7, wherein for the shaped polymer body a polymer blend of polycarbonate with polyolefin, in particular with polypropylene or polyethylene is used.

9. A conductor plate arrangement, comprising at least one conductor plate, wherein the conductor plate is a shaped polymer body according to claim 6 or 7, with at least one electrically conductive conductor path, wherein the conductor plate comprises a shaped polymer body with 0.1-10 % by weight of carbon nanotubes (CNT), based on the mass of the polymer phase(s), and wherein
a) the at least one electrically conductive conductor path comprises a metal layer, preferably a copper layer; and/or
b) comprises at least one electronic component, and wherein the at least one electronic component is connected with at least one electrically conductive conductor path of the conductor plate by an organic adhesive composition containing 0.05-10 % by weight of carbon nanotubes (CNT), based on the mass of the adhesive composition, and/or by a bond comprising a material containing carbon nanotubes (CNT), in particular one or more polymer phases containing carbon nanotubes (CNT), and/or by a soldered joint.

10. The conductor plate arrangement according to claim 9, wherein the organic adhesive composition contains at least one adhesive which is selected from the group consisting of: acrylate adhesives, phenol formaldehyde resin adhesives, silicone adhesives and polyurethane adhesives, wherein the adhesive composition preferably contains a urethane acrylate adhesive.

11. A method for the production of a conductor plate arrangement according to claim 9 or 10, comprising the steps of:
a) providing a shaped polymer body of at least one polymer phase containing carbon nanotubes (CNT), wherein the shaped polymer body comprises a polyolefin admixture of at least 10 % by weight, based on the weight of the shaped polymer body,
b) thermally treating of at least one surface of the shaped polymer body for creating the conductive structures on the surface of the shaped polymer body, wherein the thermal treatment comprises heating to a temperature which is equal to or higher than the melting temperature of the at least one polymer phase, and
c) electroplating the electrically conductive structures with a metal, preferably with copper, and/or
d) providing at least one electronic component, and
e) connecting, preferably thermally and/or electrically conductively connecting the electronic component with the at least one electrically conductive conductor path or the at least one electrically conductive region using the adhesive composition containing 0.05-10 % by weight of carbon nanotubes (CNT) and/or by creating a bond comprising a carbon nanotubes (CNT) containing material, in particular one or more polymer phases containing carbon nanotubes (CNT) and/or by creating a soldered joint.

12. The method according to claim 11, wherein the step of creating a bond according to step e) comprises
aa) energizing at least one section, in particular a surface section of the shaped polymer body or of the electrically conductive path or of the electrically conductive region, wherein the section is at least partially molten,
bb) contacting a section of the electronic component with the at least partially molten section of the shaped polymer body or of the electrically conductive path or of the electrically conductive region,
cc) forming a bond, in particular an electrically conductive bond between the section of the electronic component and the at least one section of the shaped polymer body or of the electrically conductive path or of the electrically conductive region.

13. The method according to claim 12, wherein the step of energizing at least one section of the shaped polymer body or of the electrically conductive path or of the electrically conductive region comprises
i) heating a section of the electronic component which is in contact with the shaped polymer body or with the electrically conductive conductor path and/or the electrically conductive region or which is designed for contacting with the shaped polymer body or with the electrically conductive conductor path and/or with the electrically conductive region and is contacted therewith after heating, and/or
ii) heating a section of the shaped polymer body or of the electrically conductive conductor path or of the electrically conductive region.

14. The method according to one of claims 12 or 13, wherein the step of energizing according to claim 12 or wherein the step of heating according to claim 13 is conducted by the use of a laser.

15. A use of an adhesive composition containing carbon nanotubes (CNTs) for fixing an electronic component on a shaped polymer body according to claim 6 or 7, wherein the shaped polymer body comprises a polyolefin admixture of at least 10 % by weight, based on the weight of the shaped polymer body.

16. A use of an apparatus for creating conductive structures on the surface of a shaped polymer body comprising at least one polymer phase containing carbon nanotubes (CNT), wherein the shaped polymer body comprises a polyolefin admixture of at least 10 % by weight, based on the weight of the shaped polymer body, wherein the apparatus comprises an energy source with at least one electrode being designed for energizing with which the body to be treated can be at least partially heated, wherein the conductive structures on the surface are created by targeted partial melting of the surface.

## Revendications

1. Procédé d'augmentation de la conductibilité électrique d'une surface d'un corps de formage polymère constitué d'au moins une phase polymère, qui contient des nanotubes de carbone (CNT), comprenant les étapes suivantes:
a) préparation d'un corps de formage polymère constitué d'au moins une phase polymère, qui contient des nanotubes de carbone (CNT), le corps de formage polymère comprenant une addition de polyoléfine d'au moins 10 % en poids par rapport au poids du corps de formage polymère;
b) traitement thermique de la surface du corps de formage polymère pour augmenter la conductibilité électrique de la surface traitée, le traitement thermique comprenant un chauffage à une température qui correspond à au moins la température de fusion de la au moins une phase polymère.

2. Procédé selon la revendication 1, **caractérisé en ce que** la ou les phases polymères est/sont obtenue(s) par mélange du polymère fondu avec 0,1 à 10 % en poids de nanotubes de carbone, par rapport à la masse de la ou des phases polymères.

3. Procédé selon la revendication 1 ou 2, **caractérisé en ce que** le corps de formage polymère est obtenu par fusion d'au moins une phase polymère, qui contient des nanotubes de carbone (CNT) dans une proportion comprise entre 1 et 40 % en poids avec au moins une phase polymère supplémentaire présentant une proportion plus faible de nanotubes de carbone (CNT).

4. Procédé selon une des revendications précédentes, **caractérisé en ce que** la phase polymère comprend au moins une polyoléfine, en particulier une polyoléfine cyclique ou est constituée de celle-ci; et/ou contient au moins un additif conduisant la lumière et/ou un additif conduisant la chaleur avec une conductibilité supérieure à 20 W/mK et/ou un agent moussant.

5. Procédé selon une des revendications précédentes, **caractérisé en ce que** le traitement thermique de la ou des surfaces du corps de formage polymère a lieu par contact avec un corps, un gaz ou un liquide chauffé ou par irradiation électromagnétique, en particulier irradiation laser ou IR.

6. Corps de formage polymère doté de structures conductrices sur la surface, dans lequel le corps de formage polymère comprend un additif de polyoléfine d'au moins 10 % en poids par rapport au poids du corps de formage polymère, préparé en appliquant le procédé conforme à l'une des revendications 1 à 5.

7. Corps de formage polymère selon la revendication 6, dans lequel le corps de formage polymère présente sur la surface des structures électro- ou thermoconductrices, la concentration des CNT dans les zones des structures de surface électroconductrices créées par traitement thermique étant plus élevée que dans les zones de surface non électroconductrices, les zones de surface non électroconductrices contenant des CNT.

8. Corps de formage polymère selon la revendication 6 ou 7, dans lequel un mélange de polymères constitué de polycarbonate avec une polyoléfine, en particulier avec du polypropylène ou du polyéthylène est utilisé pour le corps de formage polymère.

9. Assemblage de plaquette de circuit imprimé, comprenant au moins une plaquette de circuit imprimé, laquelle est un corps de formage polymère selon la revendication 6 ou 7 avec au moins une piste électroconductrice, la plaquette de circuit imprimé présentant un corps de formage polymère avec 0,1 à 10 % en poids de nanotubes de carbone (CNT), par rapport à la masse de la ou des phases polymère(s), et qui
a) comprend au moins une piste électroconductrice, une couche métallique, de préférence une couche de cuivre; et/ou
b) comprend un élément électronique, le au moins un élément électronique étant attaché avec au moins une piste électroconductrice de la plaquette de circuit imprimé, par une composition d'adhésif organique contenant 0,05 à 10 % en poids de nanotubes de carbone (CNT), par rapport à la masse de la composition d'adhésif et/ou par une liaison qui comprend un matériau contenant des nanotubes de carbone (CNT), en particulier une ou plusieurs phases polymères comprenant des nanotubes de carbone (CNT) et/ou par une jonction par brasage.

10. Assemblage de plaquette de circuit imprimé selon la revendication 9, dans lequel la composition d'adhésif organique contient au moins un adhésif, qui est choisi parmi le groupe constitué des adhésifs à base d'acrylate, adhésifs à base de résine phénol-formaldéhyde, adhésifs à base de silicone et adhésifs à base de polyuréthane; de préférence, la composition d'adhésif contient un adhésif à base d'uréthane-acrylate.

11. Procédé de fabrication d'un assemblage de plaquette de circuit imprimé selon la revendication 9 ou 10, comprenant les étapes de
a) préparation d'un corps de formage polymère constitué d'au moins une phase polymère, qui contient des nanotubes de carbone (CNT), le corps de formage polymère comprenant une addition de polyoléfine d'au moins 10 % en poids par rapport au poids du corps de formage polymère;
b) traitement thermique d'au moins une surface du corps de formage polymère pour la fabrication de structures conductrices sur la surface du corps de formage polymère, le traitement thermique comprenant un chauffage à une température qui correspond à au moins la température de fusion de la au moins une phase polymère, et
c) galvanisation des structures électroconductrices avec un métal, de préférence le cuivre, et/ou
d) préparation d'au moins un élément électronique, et
e) jonction, de préférence jonction thermo- et/ou électroconductrice, de l'élément électronique avec la au moins une piste électroconductrice ou la au moins une zone électroconductrice, en utilisant la composition d'adhésif contenant 0,05 à 10 % en poids de nanotubes de carbone (CNT) et/ou par réalisation d'une liaison, qui comprend un matériau contenant des nanotubes de carbone (CNT), en particulier une ou plusieurs phases polymères contenant des nanotubes de carbone (CNT), et/ou par réalisation d'une jonction par brasage.

12. Procédé selon la revendication 11, dans lequel la réalisation de la liaison selon l'étape e) comprend :
aa) apport d'énergie à au moins une section, en particulier une section de surface, du corps de formage polymère ou de la piste électroconductrice ou de la zone électroconductrice, la section fondant au moins partiellement,
bb) entrée en contact ou mise en contact d'une section de l'élément électronique avec la section au moins partiellement fondue du corps de formage polymère ou de la piste électroconductrice ou de la zone électroconductrice,
cc) former ou faire former une liaison, en particulier une liaison électroconductrice, entre la section de l'élément électronique et la au moins une section du corps de formage polymère ou de la piste électroconductrice ou de la zone électroconductrice.

13. Procédé selon la revendication 12, dans lequel l'étape d'apport d'énergie à au moins une section du corps de formage polymère ou de la piste électroconductrice ou de la zone électroconductrice comprend
i) le chauffage d'une section de l'élément électronique, qui est en contact avec le corps de formage polymère ou la piste électroconductrice ou la zone électroconductrice ou qui est conçue pour entrer en contact avec le corps de formage polymère ou la piste électroconductrice ou la zone électroconductrice et qui est mise en contact avec ceux-ci après le chauffage, et/ou
ii) le chauffage d'une section du corps de formage polymère ou de la piste électroconductrice ou de la zone électroconductrice.

14. Procédé selon l'une des revendications 12 ou 13, dans lequel l'étape d'apport d'énergie selon la revendication 12 ou l'étape de chauffage selon la revendication 13 est réalisée à l'aide d'un laser.

15. Utilisation d'une composition d'adhésif contenant des nanotubes de carbone (CNT) pour l'application d'éléments électroniques sur un corps de formage polymère selon la revendication 6 ou 7, dans laquelle le corps de formage polymère comprend une addition de polyoléfine d'au moins 10 % en poids par rapport au poids du corps de formage polymère.

16. Utilisation d'un appareil pour créer des structures conductrices sur la surface d'un corps de formage polymère, qui comprend au moins une phase polymère qui contient des nanotubes de carbone (CNT), dans laquelle le corps de formage polymère comprend une addition de polyoléfine d'au moins 10 % en poids par rapport au poids du corps de formage polymère, dans laquelle l'appareil présente une source d'énergie avec au moins une électrode, qui est prévue pour dégager une énergie, avec laquelle le corps à traiter est au moins partiellement chauffable, les structures conductrices sur la surface étant créées par une fonte ciblée de la surface.
